# EUROPEAN PATENT APPLICATION

(11) **EP 4 582 858 A1**
(43) Date of publication of application: **09.07.2025**
(21) Application number: 24744377.3
(22) Date of filing: 18.01.2024
(51) Int. Cl.: G02F 1/13, H01L 21/84

(54) **DISPLAY SUBSTRATE AND MANUFACTURING METHOD, DISPLAY PANEL, DISPLAY DEVICE, AND DETECTION METHOD**

(30) Priority: 18.01.2023 CN 202310088008
(71) Applicant: Boe Technology Group Co., Ltd., Beijing 100015 (CN); Beijing BOE Display Technology Co., Ltd., Beijing 100176 (CN)
(72) Inventor: QI, Shengmei, Beijing 100176 (CN); WANG, Jiguo, Beijing 100176 (CN); DING, Tengfei, Beijing 100176 (CN); WANG, Shijun, Beijing 100176 (CN); WANG, Yang, Beijing 100176 (CN); LIU, Jiantao, Beijing 100176 (CN); LIU, Yi, Beijing 100176 (CN); YANG, Xinlan, Beijing 100176 (CN); TAI, Yuke, Beijing 100176 (CN); QIU, Zhangjie, Beijing 100176 (CN); CHEN, Gongda, Beijing 100176 (CN); PENG, Zhou, Beijing 100176 (CN); WEI, Zhan, Beijing 100176 (CN); LIANG, Haiyao, Beijing 100176 (CN); ZHANG, Shengfeng, Beijing 100176 (CN); YU, Tianjing, Beijing 100176 (CN)
(74) Representative: Hoffmann Eitle
(86) International application number: PCT/CN2024/073134
(87) International publication number: WO 2024/153207

(57) **Abstract**

A display substrate (10), comprising a display area (AA) and a non-display area (SA). The display substrate (10) comprises a base substrate (101) and a driving circuit laver (102) provided on the base substrate (101). The driving circuit laver (102) in the non-display area (SA) comprises a photosensitive sensor (S), and the photosensitive sensor (S) comprises a photosensitive device (11). The photosensitive device (11) comprises a semiconductor portion (114), a first conductor portion (112) and a second conductor portion (113). The photosensitive device (11) further comprises a gate (111). At least part of the gate (111) is a light-transmitting portion (1111), the light-transmitting portion (1111) is made of a light-transmitting material, and the light-transmitting portion (1111) passes through the gate (111). The orthographic projection of the light-transmitting portion (1111) on the base substrate (101) overlaps the orthographic projection of the semiconductor portion (114) on the base substrate (101).

## Description

This application claims priority to Chinese Patent Application No. 202310088008.7, filed on January 18, 2023, which is incorporated herein by reference in its entirety.

### TECHNICAL FIELD

The present disclosure relates to the field of display technologies, and in particular, to a display substrate and a manufacturing method thereof, a display panel, a display apparatus and a detection method.

### BACKGROUND

With the development of display technologies, display panels with rich functions have become an irresistible trend of market development. The design for integrating a photosensor into display panels is an important research and development direction of display technologies.

### SUMMARY

In a first aspect, a display substrate is provided, and the display substrate has a display region and a non-display region. The display substrate includes a substrate and a driving circuit layer disposed on the substrate. The driving circuit layer includes a photosensor in the non-display region, and the photosensor includes a photosensitive device; the photosensitive device includes a semiconductor portion, a first conductor portion and a second conductor portion; the photosensitive device further includes a gate, and at least a portion of the gate is a light-transmitting portion; a material of the light-transmitting portion is a light-transmitting material, and the light-transmitting portion penetrates the gate. An orthographic projection of the light-transmitting portion on the substrate overlaps with an orthographic projection of the semiconductor portion on the substrate.

In some embodiments, a portion of the semiconductor portion whose orthographic projection on the substrate is non-overlapping with the gate is a first portion. The semiconductor portion further includes a lightly doped drain, and the lightly doped drain is included in the first portion.

In some embodiments, an orthographic projection of the lightly doped drain on the substrate overlaps with an orthographic projection of the light-transmitting portion on the substrate.

In some embodiments, the orthographic projection of the lightly doped drain on the substrate covers an orthographic projection of the gate on the substrate.

In some embodiments, in an extension direction of the substrate, a dimension of the lightly doped drain is less than or equal to 0.5 um.

In some embodiments, the photosensor includes two photosensitive devices; one of the two photosensitive devices outputs a photosensitive current in response to an input signal and illumination of external light on a semiconductor portion thereof, and another of the two photosensitive devices outputs a reference current in response to an input signal.

In some embodiments, in an extension direction of the substrate, dimensions of lightly doped drains of the two photosensitive devices are same or different.

In some embodiments, the display substrate further includes a black matrix disposed on the driving circuit layer; an orthographic projection of the black matrix on the substrate covers an orthographic projection of the another one of the two photosensitive devices on the substrate, and the orthographic projection of the black matrix on the substrate is non-overlapping with an orthographic projection of the one of the two photosensitive devices on the substrate.

In some embodiments, the photosensor further includes a low-temperature polycrystalline silicon thin film transistor; the low-temperature polycrystalline silicon thin film transistor includes an active layer disposed in a same layer as the semiconductor portion of the photosensitive device, a source disposed in a same layer as the first conductor portion of the photosensitive device, and a drain disposed in a same layer as the second conductor portion of the photosensitive device; the photosensitive device outputs a photosensitive current in response to an input signal and illumination of external light on the semiconductor portion, and the low-temperature polycrystalline silicon thin film transistor outputs a reference current in response to an input signal.

In some embodiments, the low-temperature polycrystalline silicon thin film transistor is of a top-gate structure; the source of the low-temperature polycrystalline silicon thin film transistor and the first conductor portion of the photosensitive device receive a first signal, the drain of the low-temperature polycrystalline silicon thin film transistor receives a second signal, the second conductor portion of the photosensitive device receives a third signal, and a gate of the low-temperature polycrystalline silicon thin film transistor receives a fourth signal.

In some embodiments, the display substrate further includes a black matrix disposed on the driving circuit layer; an orthographic projection of the black matrix on the substrate covers an orthographic projection of the low-temperature polycrystalline silicon thin film transistor on the substrate, and the orthographic projection of the black matrix on the substrate is non-overlapping with an orthographic projection of the photosensitive device on the substrate.

In some embodiments, the display substrate includes a semiconductor layer that is patterned and disposed on the substrate; the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from a semiconductor material of the semiconductor layer by conductorization.

The display substrate further includes: a gate insulating layer covering the semiconductor layer and an exposed portion of the substrate, a gate of the low-temperature polycrystalline silicon thin film transistor disposed on the gate insulating layer, and an interlayer insulating layer covering the gate and an exposed portion of the gate insulating layer. The interlayer insulating layer includes a plurality of first via holes extending to the drain and the second conductor portion.

The display substrate further includes a plurality of first auxiliary conductor portions that are patterned and disposed on the interlayer insulating layer for receiving input signals; each first via hole is filled with a respective first auxiliary conductor portion.

The display substrate further includes a planarization layer disposed on the interlayer insulating layer and surrounding the first auxiliary conductor portions.

In some embodiments, the photosensitive device is a thin film transistor. The semiconductor portion of the photosensitive device is an active layer, the first conductor portion of the photosensitive device is a source, and the second conductor portion of the photosensitive device is a drain. The gate of the photosensitive device receives a fifth signal, and the photosensitive device outputs the photosensitive current in response to a first signal, a third signal, the fifth signal and the illumination of external light on the semiconductor portion.

In some embodiments, the display substrate includes a semiconductor layer that is patterned and disposed on the substrate. The semiconductor layer includes the active layer, the source and the drain of the low-temperature polycrystalline silicon thin film transistor, as well as the semiconductor portion, the first conductor portion and the second conductor portion of the photosensitive device. The source and the drain, and the first conductor portion and the second conductor portion are formed from a semiconductor material of the semiconductor layer by conductorization.

The display substrate further includes: a gate insulating layer covering the semiconductor layer and an exposed portion of the substrate, a gate of the low-temperature polycrystalline silicon thin film transistor disposed on the gate insulating layer, and an interlayer insulating layer covering the gate and an exposed portion of the gate insulating layer. The interlayer insulating layer includes a plurality of first via holes extending to the drain and the second conductor portion and a third via hole extending to the gate insulating layer.

The display substrate further includes a plurality of first auxiliary conductor portions and a plurality of third auxiliary conductor portions that are both patterned and disposed on the interlayer insulating layer for receiving input signals, wherein each first via hole is filled with a respective first auxiliary conductor portion.

The display substrate further includes a planarization layer disposed on the interlayer insulating layer, the third auxiliary conductor portions and an exposed portion of the gate insulating layer, wherein the planarization layer surrounds the first auxiliary conductor portions, and the planarization layer includes a fourth via hole extending to a third auxiliary conductor portion and a fifth via hole extending to the gate insulating layer; an orthographic projection of the fifth via hole on the substrate is located within an orthographic projection of the semiconductor portion of the photosensitive device on the substrate, and the orthographic projection of the fifth via hole on the substrate is located within an orthographic projection of the third via hole on the substrate.

The display substrate further includes the gate of the photosensitive device disposed on the planarization layer; the fourth via hole and the fifth via hole are filled with the gate of the photosensitive device, and the gate of the photosensitive device is connected to the third auxiliary conductor portion through the fourth via hole.

In some embodiments, the display substrate includes a semiconductor layer that is patterned and disposed on the substrate. The semiconductor layer includes the active layer, the source and the drain of the low-temperature polycrystalline silicon thin film transistor, as well as the semiconductor portion, the first conductor portion and the second conductor portion of the photosensitive device. The source and the drain, and the first conductor portion and the second conductor portion are formed from a semiconductor material of the semiconductor layer by conductorization.

The display substrate further includes: a gate insulating layer covering the semiconductor layer and an exposed portion of the substrate, a gate of the low-temperature polycrystalline silicon thin film transistor disposed on the gate insulating layer, and an interlayer insulating layer covering the gate and an exposed portion of the gate insulating layer. The interlayer insulating layer includes a plurality of first via holes extending to the drain and the second conductor portion.

The display substrate further includes a plurality of first auxiliary conductor portions and a third auxiliary conductor portion that are patterned and disposed on the interlayer insulating layer for receiving input signals; each first via hole is filled with a respective first auxiliary conductor portion.

The display substrate further includes a planarization layer disposed on the interlayer insulating layer and an exposed portion of the gate insulating layer. The planarization layer surrounds the first auxiliary conductor portions and the third auxiliary conductor portion, and the planarization layer includes a sixth via hole extending to the gate insulating layer. An orthographic projection of the sixth via hole on the substrate is located within an orthographic projection of the semiconductor portion on the substrate.

The display substrate further includes the gate of the photosensitive device that is patterned and disposed on the planarization layer; the gate of the photosensitive device is connected to the third auxiliary conductor portion, and the sixth via hole is filled with the gate of the photosensitive device.

In some embodiments, the display substrate includes a semiconductor layer that is patterned and disposed on the substrate. The semiconductor layer includes the active layer, the source and the drain of the low-temperature polycrystalline silicon thin film transistor, as well as the semiconductor portion, the first conductor portion and the second conductor portion of the photosensitive device. The source and drain, and the first conductor portion and second conductor portion are formed from a semiconductor material of the semiconductor layer by conductorization.

The display substrate further includes: a gate insulating layer covering the semiconductor layer and an exposed portion of the substrate, and a gate layer that is patterned and disposed on the gate insulating layer. The gate layer includes a gate of the low-temperature polycrystalline silicon thin film transistor and the gate of the photosensitive device; the gate of the low-temperature polycrystalline silicon thin film transistor includes a first gate and a second gate that are stacked, the gate of the photosensitive device is disposed in a same layer as the first gate, and the first gate is made of a transparent material.

The display substrate further includes an interlayer insulating layer covering the gate layer and an exposed portion of the gate insulating layer; the interlayer insulating layer includes a plurality of first via holes extending to the drain and the second conductor portion.

The display substrate further includes a plurality of first auxiliary conductor portions that are patterned and disposed on the interlayer insulating layer for receiving input signals; each first via hole is filled with a respective first auxiliary conductor portion.

The display substrate further includes a planarization layer disposed on the interlayer insulating layer and surrounding the first auxiliary conductor portions.

In a second aspect, a liquid crystal display panel is provided, and the liquid crystal display panel includes the display panel according to any one of the above embodiments; the liquid crystal display panel further includes: a light-blocking layer and a buffer layer covering the light-blocking layer that are disposed on the substrate of the display substrate, and a common electrode disposed on the planarization layer, a passivation layer covering the common electrode, and a pixel electrode disposed on the passivation layer. The buffer layer is located on a side of an active layer of the photosensitive device of the display substrate proximate to the substrate; an orthographic projection of the light-blocking layer on the substrate covers an orthographic projection of an active layer of a low-temperature polycrystalline silicon thin film transistor on the substrate and covers an orthographic projection of the semiconductor portion of the photosensitive device of the display substrate on the substrate.

In a third aspect, an electroluminescent diode display panel is provided, and the electroluminescent diode display panel includes the display substrate according to any one of the above embodiments.

In a fourth aspect, a display apparatus is provided. The display apparatus includes: the liquid crystal display panel according to the second aspect or electroluminescent diode display panel according to the third aspect, and a driver chip. The driver chip is used to output a signal to the photosensor of the display substrate of the liquid crystal display panel or the electroluminescent diode display panel to drive the photosensitive device of the photosensor.

In some embodiments, the photosensor further includes a low-temperature polycrystalline silicon thin film transistor, and the driver chip is further used to output a signal to the photosensor of the display substrate of the liquid crystal display panel or the electroluminescent diode display panel to drive the low-temperature polycrystalline silicon thin film transistor of the photosensor.

In some embodiments, the display apparatus further includes a sampling circuit and an operation circuit; the sampling circuit is used to obtain a current difference between a reference current and a photosensitive current output by the photosensor and to convert the current difference into a voltage difference; and the operation circuit is used to obtain illuminance of external light based on the voltage difference.

In a fifth aspect, a manufacturing method of a display substrate is provided, and the method includes: forming a driving circuit layer on a substrate. The driving circuit layer includes a photosensor in the non-display region, and the photosensor includes a photosensitive device. The photosensitive device includes a semiconductor portion, a first conductor portion and a second conductor portion; the photosensitive device further includes a gate, and at least a portion of the gate is a light-transmitting portion. A material of the light-transmitting portion is a light-transmitting material, and the light-transmitting portion penetrates through the gate. An orthographic projection of the light-transmitting portion on the substrate overlaps with an orthographic projection of the semiconductor portion on the substrate.

In some embodiments, forming the driving circuit layer on the substrate further includes: forming the photosensor located in the non-display region. The photosensor further includes a low-temperature polycrystalline silicon thin film transistor; the low-temperature polycrystalline silicon thin film transistor includes an active layer disposed in a same layer as the semiconductor portion of the photosensitive device, a source disposed in a same layer as the first conductor portion of the photosensitive device, and a drain disposed in a same layer as the second conductor portion of the photosensitive device; the photosensitive device outputs a photosensitive current in response to an input signal and illumination of external light on the semiconductor portion, and the low-temperature polycrystalline silicon thin film transistor outputs a reference current in response to an input signal.

In some embodiments, after forming the driving circuit layer on the substrate, the manufacturing method of the display substrate further includes:
forming a black matrix, in the non-display region, on the driving circuit layer, an orthographic projection of the black matrix on the substrate covering an orthographic projection of one of two photosensitive devices on the substrate, and the orthographic projection of the black matrix on the substrate being non-overlapping with an orthographic projection of another of the two photosensitive devices on the substrate; or forming a black matrix, in the non-display region, on the driving circuit layer, an orthographic projection of the black matrix on the substrate covering an orthographic projection of the low-temperature polycrystalline silicon thin film transistor on the substrate, and the orthographic projection of the black matrix on the substrate being non-overlapping with an orthographic projection of the photosensitive device on the substrate.

In some embodiments, forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming a interlayer insulating layer that is patterned by using a semi-transparent mask, wherein the semi-transparent mask has different transmittances corresponding to the gate of the low-temperature polycrystalline silicon thin film transistor and the gate portion of the photosensitive device; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate;
etching the gate portion of the photosensitive device to expose the gate insulating layer;
forming a plurality of first via holes extending to the drain and the second conductor portion in the interlayer insulating layer;
forming a plurality of first auxiliary conductor portions that are patterned on the interlayer insulating layer, wherein each first via hole is filled with a respective first auxiliary conductor portion; and
forming a planarization layer on the interlayer insulating layer and an exposed portion of the gate insulating layer, wherein the planarization layer surrounds the first auxiliary conductor portions.

**In** some embodiments, forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer by using a semi-transparent mask, wherein the gate layer includes a gate of the low-temperature polycrystalline silicon thin film transistor and a gate portion of the photosensitive device; the semi-transparent mask has different transmittances corresponding to the gate and the gate portion;
performing a first conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
etching the gate portion of the photosensitive device to expose the gate insulating layer;
performing a second conductorization process on the semiconductor layer;
forming an interlayer insulating layer on the gate and an exposed portion of the gate insulating layer, wherein the interlayer insulating layer includes a plurality of first via holes extending to the drain and the second conductor portion;
forming a plurality of first auxiliary conductor portions that are patterned on the interlayer insulating layer, wherein each first via hole is filled with a respective first auxiliary conductor portion; and
forming a planarization layer on the interlayer insulating layer, wherein the planarization layer surrounds the first auxiliary conductor portions.

**In** some embodiments, forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming an interlayer insulating layer that is patterned by using a semi-transparent mask, wherein the semi-transparent mask has different transmittances corresponding to the gate of the low-temperature polycrystalline silicon thin film transistor and the gate portion of the photosensitive device respectively; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate;
etching the gate portion of the photosensitive device to expose the gate insulating layer;
forming a plurality of first via holes extending to the drain and second conductor portion in the interlayer insulating layer and forming a third via hole extending to the gate insulating layer in the interlayer insulating layer;
forming a plurality of first auxiliary conductor portions and a third auxiliary conductor portion that are patterned on the interlayer insulating layer, wherein each first via hole is filled with a respective first auxiliary conductor portion;
forming a planarization layer on the interlayer insulating layer, the third auxiliary conductor portion and a portion of gate insulating layer exposed by the third via hole, wherein the planarization layer surrounds the first auxiliary conductor portions;
forming a fourth via hole extending to the third auxiliary conductor portion in the planarization layer and forming a fifth via hole extending to the gate insulating layer in the planarization layer, wherein an orthographic projection of the fifth via hole on the substrate is located within the orthographic projection of the semiconductor portion of the photosensitive device on the substrate, and the orthographic projection of the fifth via hole on the substrate is located within an orthographic projection of the third via hole on the substrate; and
forming the gate of the photosensitive device that is patterned on the planarization layer, wherein the fourth via hole and the fifth via hole are filled with the gate of the photosensitive device, and the gate of the photosensitive device is connected to the third auxiliary conductor portion through the fourth via hole.

In some embodiments, forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming an interlayer insulating layer on the gate layer and an exposed portion of the gate insulating layer, wherein the interlayer insulating layer includes a plurality of first via holes extending to the drain and the second conductor portion;
forming a plurality of first auxiliary conductor portions and a third auxiliary conductor portion that are patterned on the interlayer insulating layer, wherein each first via hole is filled with a respective first auxiliary conductor portion;
forming a planarization material layer on the interlayer insulating layer, wherein the planarization material layer surrounds the first auxiliary conductor portions and the third auxiliary conductor portion;
forming a planarization layer including a sixth via hole extending to the gate insulating layer in the planarization material layer and etching the gate portion through the sixth via hole to expose the gate insulating layer by using a semi-transparent mask, wherein an orthographic projection of the sixth via hole on the substrate is located within the orthographic projection of the gate portion on the substrate; the semi-transparent mask has different transmittances corresponding to the gate of the low-temperature polycrystalline silicon thin film transistor and the gate portion of the photosensitive device; and
forming the gate of the photosensitive device that is patterned on the planarization layer, wherein the sixth via hole is filled with the gate of the photosensitive device, and the gate of the photosensitive device is connected to the third auxiliary conductor portion.

In some embodiments, forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a first gate material layer and a second gate material layer that are stacked on the gate insulating layer, wherein the first gate material layer is made of a transparent material;
patterning the first gate material layer and the second gate material layer that are stacked by using a semi-transparent mask to form a gate layer, and performing a conductorization process on the semiconductor layer, wherein the gate layer includes a gate of the low-temperature polycrystalline silicon thin film transistor and the gate of the photosensitive device; the gate of the low-temperature polycrystalline silicon thin film transistor includes a first gate formed by patterning the first gate material layer, and a second gate formed by patterning the second gate material layer, and the first gate and the second gate are stacked; the gate of the photosensitive device is disposed in a same layer as the first gate; the semi-transparent mask has different transmittances corresponding to the gate of the low-temperature polycrystalline silicon thin film transistor and the gate of the photosensitive device; the semiconductor structure of the low-temperature polycrystalline silicon thin film transistor is formed into an active layer, and a source and a drain respectively disposed on two sides of the active layer; the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate of the photosensitive device on the substrate and an orthographic projection of the semiconductor portion on the substrate overlap;
forming an interlayer insulating layer covering the gate layer and an exposed portion of the gate insulating layer, wherein the interlayer insulating layer includes a plurality of first via holes extending to the drain and the second conductor portion;
forming a plurality of first auxiliary conductor portions that are patterned on the interlayer insulating layer, wherein each first via hole is filled with a respective first auxiliary conductor portion; and
forming a planarization layer on the interlayer insulating layer, wherein the planarization layer surrounds the first auxiliary conductor portions.

In a sixth aspect, an ambient light detection method with the display apparatus that is according to the fourth aspect is provided, and the ambient light detection method includes:
the driver chip outputting driving signals to the photosensor of the display apparatus to drive the low-temperature polycrystalline silicon thin film transistor and the photosensitive device of the photosensor, such that the low-temperature polycrystalline silicon thin film transistor outputs a reference current, and the photosensitive device outputs a photosensitive current in response to illumination of external light;
obtaining, based on the reference current and the photosensitive current that are output by the photosensor, a current difference between the reference current and the photosensitive current, and converting the current difference into a voltage difference through a preset sampling circuit; and
obtaining, based on the voltage difference, illuminance of the external light through a preset operation circuit.

### BRIEF DESCRIPTION OF THE DRAWINGS

In order to describe the technical solutions of the present disclosure more clearly, the accompanying drawings to be used in some embodiments of the present disclosure will be briefly introduced below. Obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display substrate in the related art;
FIG. 2 is a structural diagram of a display apparatus, in accordance with some embodiments of the present disclosure;
FIG. 3a is a structural diagram of a display panel, in accordance with some embodiments of the present disclosure;
FIG. 3b is a structural diagram of another display panel, in accordance with some embodiments of the present disclosure;
FIG. 4 is a structural diagram of a display substrate, in accordance with some embodiments of the present disclosure;
FIG. 5 is a diagram illustrating a current-voltage (I-V) characteristic curve of a photosensitive device in FIG. 4;
FIG. 6 is a diagram illustrating a variation curve of an output current of a photosensitive device in FIG. 4 with ambient light illuminance;
FIG. 7 is a structural diagram of another display substrate, in accordance with some embodiments of the present disclosure;
FIG. 8 is a structural diagram of yet another display substrate, in accordance with some embodiments of the present disclosure;
FIG. 9 is a diagram illustrating an I-V characteristic curve of a photosensitive device in FIG. 8;
FIG. 10 is a diagram illustrating a variation curve of an output current of a photosensitive device in FIG. 8 with ambient light illuminance;
FIG. 11 is a structural diagram of still yet another display substrate, in accordance with some embodiments of the present disclosure;
FIG. 12 is a structural diagram of still yet another display substrate, in accordance with some embodiments of the present disclosure;
FIG. 13 is a structural diagram of still yet another display substrate, in accordance with some embodiments of the present disclosure;
FIG. 14 is a structural diagram of still yet another display substrate, in accordance with some embodiments of the present disclosure;
FIG. 15 is a block diagram of a display apparatus, in accordance with some embodiments of the present disclosure;
FIG. 16 is a schematic diagram illustrating a circuit of a photosensor consisting of a low-temperature polycrystalline silicon thin film transistor and a photosensitive device, in accordance with some embodiments of the present disclosure;
FIG. 17 is a structural diagram of still yet another display substrate, in accordance with some embodiments of the present disclosure;
FIGS. 18a to 18n are each a structural diagram of a display substrate at a stage of a manufacturing process, in accordance with some embodiments of the present disclosure;
FIGS. 19a to 19g are each a structural diagram of a display substrate at a stage of a manufacturing process, in accordance with some other embodiments of the present disclosure;
FIGS. 20a to 20c are each a structural diagram of a display substrate at a stage of a manufacturing process, in accordance with still some other embodiments of the present disclosure;
FIGS. 21a to 21n are each a structural diagram of a display substrate at a stage of a manufacturing process, in accordance with still some other embodiments of the present disclosure;
FIGS. 22a to 22h are each a structural diagram of a display substrate at a stage of a manufacturing process, in accordance with still some other embodiments of the present disclosure;
FIG. 23 is a flow diagram of a manufacturing method of a display substrate, in accordance with some embodiments of the present disclosure;
FIGS. 24a to 24c are each a top view of a display substrate, in accordance with some embodiments of the present disclosure; and
FIGS. 25a to 25b are each a schematic diagram illustrating photosensitive currents of a display substrate, in accordance with some embodiments of the present disclosure.

### DETAILED DESCRIPTION

The technical solutions in some embodiments of the present disclosure will be clearly and completely described below in conjunction with the accompanying drawings. Obviously, the embodiments to be described are merely some but not all embodiments of the present disclosure. All other embodiments obtained by a person of ordinary skill in the art based on the embodiments of the present disclosure should fall within the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first" and "second" are used for descriptive purposes only, and cannot be construed as indicating or implying the relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the terms "coupled", "connected", and derivatives thereof may be used. The term "connected" should be understood in a broad sense; for example, the term "connected" may represent a fixed connection, a detachable connection, or a one-piece connection; it may represent a direct connection or an indirect connection through an intermediate medium. The term "coupled" indicates, for example, that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if", depending on the context, is optionally construed as "when" or "in a case where" or "in response to determining that" or "in response to detecting". Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]".

The use of the phrase "applicable to" or "configured to" herein means an open and inclusive expression, which does not exclude devices that are applicable to or configured to perform additional tasks or steps.

In addition, the use of the phrase "based on" is meant to be open and inclusive, since a process, step, calculation or other action that is "based on" one or more of the stated conditions or values may, in practice, be based on additional conditions or values exceeding those stated.

As used herein, the term such as "about", "substantially", or "approximately" includes a stated value and an average value within an acceptable range of deviation of a particular value; the acceptable range of deviation is determined, for example, by a person of ordinary skill in the art, considering measurement in question and errors (i.e., limitations of a measurement system) associated with measurement of a particular quantity.

As used herein, the term such as "parallel", "perpendicular", or "equal" includes a stated condition and a condition similar to the stated condition within an acceptable range of deviation; the acceptable range of deviation is determined, for example, by a person of ordinary skill in the art, considering measurement in question and errors (i.e., limitations of a measurement system) associated with measurement of a particular quantity. For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; the term "equal" includes absolute equality and approximate equality, and an acceptable range of deviation of the approximate equality may be, for example, that a difference between two equals is less than or equal to 5% of either of the two equals.

It will be understood that, in a case where a layer or element is referred to as being on another layer or substrate, it may be that the layer or element is directly on the another layer or substrate, or it may be that intermediate layer(s) exist between the layer or element and the another layer or substrate.

Exemplary embodiments are described herein with reference to sectional views and/or plan views which serve as idealized exemplary drawings. In the accompanying drawings, thicknesses of layers and sizes of regions are enlarged for clarity. Thus, variations in shape relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of the regions in an apparatus, and are not intended to limit the scope of the exemplary embodiments.

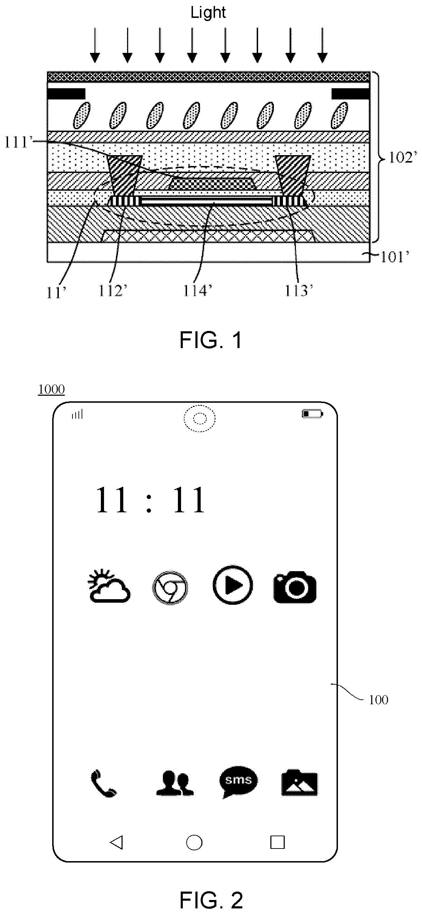

FIG. 1 is a structural diagram of a display substrate in the related art.

Referring to FIG. 1, a display substrate 10' includes a substrate 101' and a driving circuit layer 102' disposed on a side of the substrate 101'; the driving circuit layer 102' includes a photosensitive device 11', and the photosensitive device 11' is a low-temperature polycrystalline silicon (LTPS) thin film transistor. The photosensitive device 11' includes a conductor layer and a gate 111'; an active layer includes a semiconductor portion 114', the gate 111' is located on the semiconductor portion 114', and the gate 111' is a light-blocking pattern. The photosensitive device 11' outputs a current in response to an input signal and external incident light on the semiconductor portion 114'. Since the gate 111' is opaque, in a case where light enters the display substrate 10' from a side of the semiconductor portion 114' away from the gate 111', the light basically cannot be incident on the semiconductor portion 114' from the side where the gate 111' is located, so that the output current value is small, and the current changes less as the luminous intensity of the light changes. As a result, the display effect of the display panel is affected.

In order to alleviate the above problems, embodiments of the present disclosure provide a display apparatus. The display apparatus is an electronic apparatus having an image (including static images or moving images, where the moving images may be a video) display function. For example, the display apparatus may be any one of, but is not limited to, a display, a television, a billboard, a digital photo, a laser printer with display function, a telephone, a mobile phone, a personal digital assistant (PDA), a digital camera, a portable camcorder, a viewfinder, a navigator, a piece of large-area wall, a home appliance, an information query device (e.g., a business query device for e-government, banks, hospitals, or electricity, etc.), a monitor, an electronic picture screen, a virtual reality (VR) display device, an augmented reality (AR) display device, and a vehiclemounted display.

FIG. 2 is a structural diagram of a display apparatus, in accordance with some embodiments.

Referring to FIG. 2, a display apparatus 1000 includes a display panel 100. The display panel 100 is used to display images; depending on the difference of the display principle, the display panel 100 may be any one of an organic light-emitting diode (OLED) display panel, a quantum dot light-emitting diode (QLED) display panel, a mini LED or micro LED display panel and a liquid crystal display (LCD) panel; depending on whether the display panel 100 is bendable, the display panel 100 may be a rigid display panel or a flexible display panel.

In some embodiments, the display apparatus 1000 further includes a driver chip (not shown in the figure), and the driver chip is coupled to the display panel and is used to output a signal to the display panel 100 to drive the display panel 100. For example, the display panel 100 includes a photosensor, and the driver chip is coupled to the photosensor and outputs a signal to the photosensor to drive the photosensor.

In some embodiments, the display apparatus 1000 further includes a sampling circuit and an operation circuit; the sampling circuit is coupled to the display panel 100, and the operation circuit is coupled to the sampling circuit. The sampling circuit is used to obtain a current difference based on current values output by the photosensor of the display panel 100 and convert the current difference into a voltage difference. The operation circuit is used to obtain luminance of external light based on the voltage difference. The luminance here may refer to illuminance Φ of light.

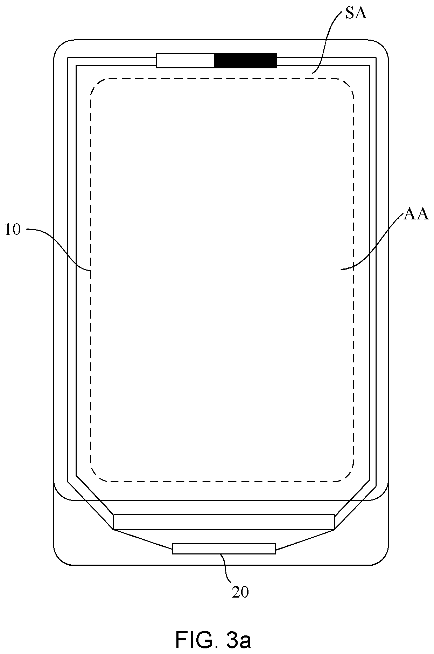

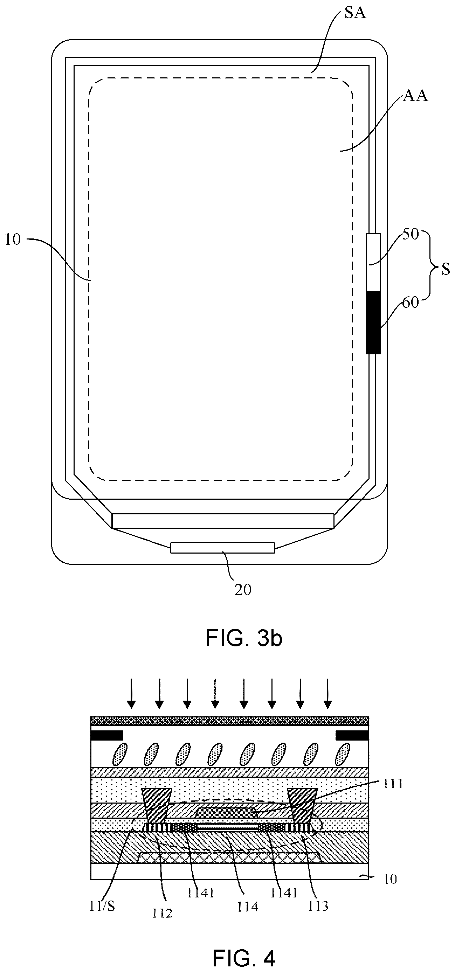

FIG. 3a is a structural diagram of a display panel, in accordance with some embodiments of the present disclosure. FIG. 3b is a structural diagram of another display panel, in accordance with some embodiments of the present disclosure.

Referring to FIGS. 3a and 3b, the display panel 100 includes a display region AA and a non-display region SA; the display region AA is a region of the display panel 100 for displaying images, and the non-display region SA is the remaining region of the display panel 100 except the display region AA. The non-display region SA may be located on at least one side (e.g., one side or multiple sides) of the display region AA; for example, the non-display region SA may be arranged surrounding the display region AA.

The display panel 100 includes a display substrate 10. The structure of the display substrate 10 will be described in detail below. The display substrate 10 is connected to a circuit board 20. The circuit board 20 may be a rigid printed circuit board (PCB) or a flexible printed circuit (FPC) board.

With continued reference to FIGS. 3a and 3b, the display substrate 10 includes a display region AA and a non-display region SA; the display region AA of the display substrate 10 corresponds to the display region AA of the display panel 100, and the non-display region SA of the display substrate 10 corresponds to the remaining region of the display substrate 10 except the display region AA. The non-display region SA may be located on at least one side (e.g., one side or multiple sides) of the display region AA; for example, the non-display region SA may be arranged surrounding the display region AA.

FIG. 4 is a structural diagram of a display substrate, in accordance with some embodiments of the present disclosure.

Referring to FIG. 4, the display substrate 10 includes a substrate 101 and a driving circuit layer 102. The substrate 101 serves as a support. The substrate 101 may be configured according to actual needs. For example, the substrate 101 may be a rigid substrate, and a material of the rigid substrate may be glass or polymethyl methacrylate (PMMA); alternatively, the substrate 101 may be a flexible substrate, and a material of the flexible substrate may be polyethylene terephthalate (PET), polyethylene naphthalate two formic acid glycol ester (PEN), ultra-thin glass or polyimide (PI).

The driving circuit layer 102 is disposed on a side of the substrate 101. The driving circuit layer includes a photosensor S in the non-display region SA, and the photosensor S is used to measure illuminance of surrounding ambient light and output a corresponding current. The photosensor S may be connected to a driver chip, and may also be connected to a sampling circuit.

The photosensor S includes a photosensitive device 11, and the photosensitive device 11 is used to be coupled to a driver chip; the driver chip outputs a signal to the photosensitive device 11 to drive the photosensitive device. The photosensitive device 11 is further coupled to a sampling circuit and outputs a current Id (hereinafter, the current output by the photosensitive device 11 is referred to as a photosensitive current) to the sampling circuit. The photosensitive device 11 includes an active layer and a gate 111; the active layer includes a first conductor portion 112, a second conductor portion 113, and a semiconductor portion 114 used to connect the first conductor portion 112 and the second conductor portion 113; the gate 111 is located on a side of the semiconductor portion 114 away from the substrate 101.

In some embodiments, the semiconductor portion 114 of the photosensitive device 11 includes a lightly doped drain (LDD) 1141. The LDD 1141 is a lightly doped drain region, near the first conductor portion 112 or the second conductor portion 113, of the semiconductor portion 114, so that the lightly doped drain region is subjected to a part of the voltage, which may prevent the hot-electron degradation effect. A portion of the semiconductor portion 114 whose orthographic projection on the substrate 101 is non-overlapping with the gate 111 is a first portion, and the LDD 1141 is located in the first portion. In this way, since the first portion is not covered by the gate 111, in a case where light enters the display substrate 10, the light may be incident on a region where the LDD 1141 is located by passing through a gap between the gate 111 and the first conductor portion 112 or a gap between the gate 111 and the second conductor portion 113.

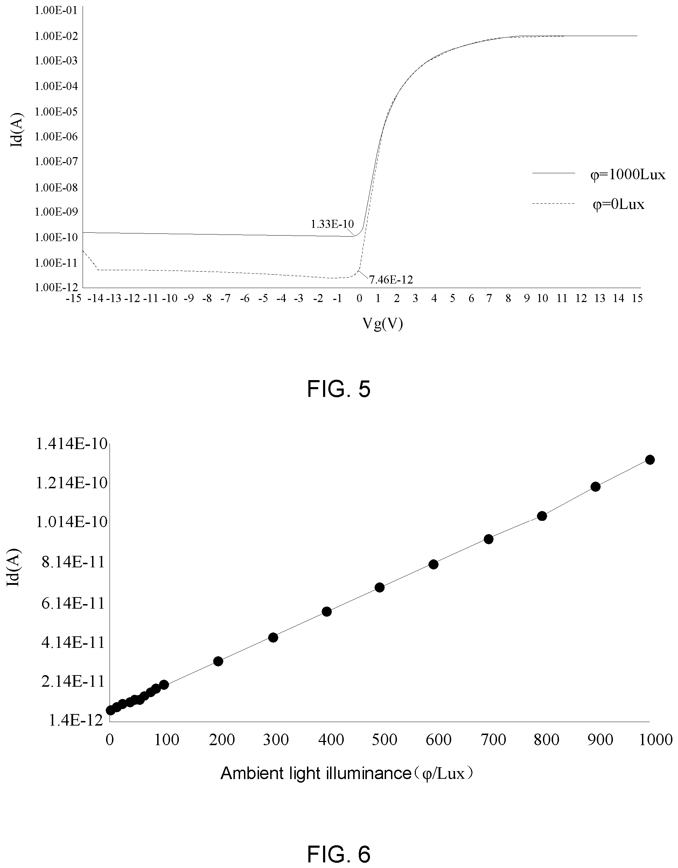

FIG. 5 shows a current-voltage (I-V) characteristic curve of a photosensitive device in FIG. 4; FIG. 6 shows a variation curve of an output current of a photosensitive device in FIG. 4 with ambient light illuminance.

Referring to FIG. 5, in a case where the ambient light illuminance φ is increased from dark (0 Lux) to 1000 Lux and the voltage Vg is equal to 0 V (Vg = 0 V, i.e., the voltage remaining unchanged), the output current Id of the photosensitive device 11 is increased from 7.46*10⁻¹² A to 1.33*10⁻¹⁰ A. Obviously, as the ambient light illuminance φchanges, the output current Id of the photosensitive device 11 changes significantly, which means that the photosensitive device 11 has certain photosensitive characteristics.

Referring to FIG. 6, as the ambient light illuminance φ is increased, for example, increased from 0 Lux to 1000 Lux, the output current Id of the photosensitive device 11 is linearly increased. As can be seen from FIG. 6, the output current Id of the photosensitive device 11 is in a range of 7.46*10⁻¹² A to 1.33*10⁻¹⁰ A, and the output currents Id and the ambient light illuminance φ are in one-to-one correspondence, which means that the photosensitive device 11 has a photosensitivity function.

Therefore, it can be seen that the LDD 1141 included in the semiconductor portion 114 of the photosensitive device 11 may help to improve the photosensitivity of the photosensitive device 11.

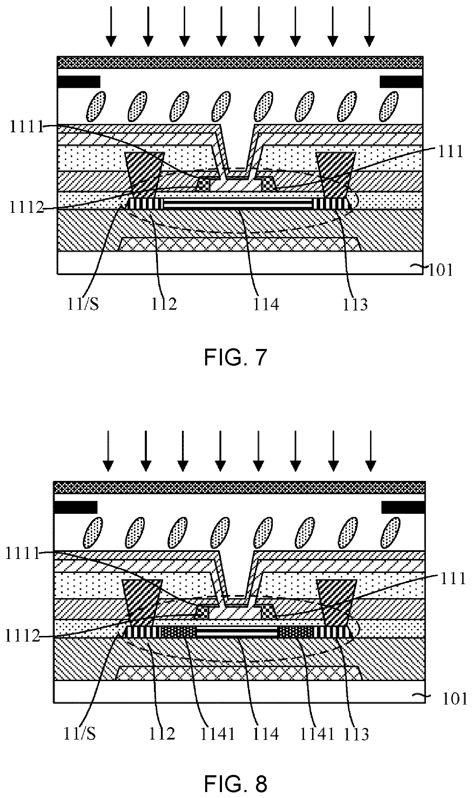

FIG. 7 is a structural diagram of a display substrate, in accordance with some other embodiments of the present disclosure.

In some embodiments, referring to FIG. 7, at least a portion of the gate 111 of the photosensitive device 11 is a light-transmitting portion 1111; a material of the light-transmitting portion 1111 is a light-transmitting material, and the light-transmitting material may be a material through which light can be transmitted, such as indium zinc oxide (IZO), or indium zinc oxide (IZO). For example, a portion of the gate 111 of the photosensitive device 11 is the light-transmitting portion 1111, and another portion of the gate 111 of the photosensitive device 11 is a light-blocking portion 1112; a material of the light-blocking portion 1112 is a light-blocking material through which light cannot be transmitted, such as molybdenum (Mo) or other metal materials.

The light-transmitting portion 1111 penetrates the gate 111; that is, in a thickness direction of the display substrate 10, the light-transmitting portion 1111 penetrates a film layer where the gate 111 is located. The upper and lower sides of the light-transmitting portion 1111 are not covered by a light-blocking material, and light can be transmitted through the light-transmitting portion 1111. In an extension direction of the substrate 101, the light-blocking portion 1112 may be located on a same side as the light-transmitting portion 1111, or may be located on two sides of the light-transmitting portion 1111. In some possible implementations, the gate 111 of the photosensitive device 11 only includes the light-transmitting portion 1111.

In the thickness direction of the display substrate 10, the light-transmitting portion 1111 overlaps with the semiconductor portion 114. To be specific, an orthographic projection of the light-transmitting portion 1111 on the substrate 101 overlaps with an orthographic projection of the semiconductor portion 114 on the substrate 101. In a case where light enters the display substrate 10 from a side of the semiconductor portion 114 away from the gate 111, the light is incident on the semiconductor portion 114 through a portion of the light-transmitting portion 1111 overlapping with the semiconductor portion 114, and the greater the overlapping region of the light-transmitting portion 1111 and the semiconductor portion 114, the more light can be incident on the semiconductor portion 114.

FIG. 8 is a structural diagram of a display substrate, in accordance with some embodiments of the present disclosure.

In some embodiments, referring to FIG. 8, at least a portion of the gate 111 of the photosensitive device 11 is the light-transmitting portion 1111; the semiconductor portion 114 of the photosensitive device 11 includes an LDD 1141, and the LDD 1141 is included in the first portion. In this way, since the first portion is not covered by the gate 111, in the case where light enters the display substrate 10, the light may be incident on a region where the LDD 1141 is located by passing through a gap between the gate 111 and the first conductor portion 112 or a gap between the gate 111 and the second conductor portion 113, and the light may also be incident on the semiconductor portion 114 through the light-transmitting portion 1111. A doping process is performed on the semiconductor portion 114 to increase carriers such as electrons or holes, so that more photosensitive current may be generated in the case where the LDD 1141 is irradiated.

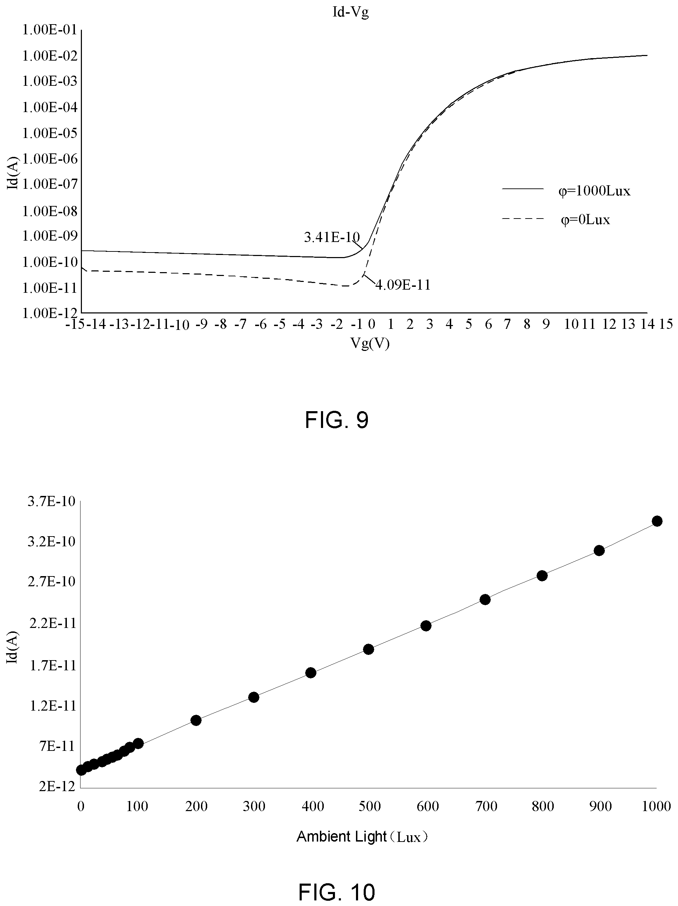

FIG. 9 is a diagram illustrating an I-V characteristic curve of the photosensitive device in FIG. 8. FIG. 10 is a diagram illustrating a variation curve of an output current of a photosensitive device in FIG. 8 with ambient light illuminance.

Referring to FIG. 9, in the case where the ambient light illuminance φ is increased from dark (0 Lux) to 1000 Lux and the voltage Vg is equal to 0 V (Vg = 0 V, i.e., the voltage remains unchanged), the output current Id of the photosensitive device 11 is increased from 4.09*10⁻¹¹ A to 3.41*10⁻¹¹ A. Obviously, as the ambient light illuminance changes, the output current Id of the photosensitive device 11 changes significantly, which means that the photosensitive device 11 has certain photosensitive characteristics.

Referring to FIG. 10, as the ambient light illuminance φ is increased, for example, increased from 0 Lux to 1000 Lux, the output current Id of the photosensitive device 11 is linearly increased. As can be seen from FIG. 6, the output current Id of the photosensitive device 11 is in a range of 4.09*10⁻¹¹ A to 3.41*10⁻¹⁰ A, and the output currents Id and the ambient light illuminance φ are in one-to-one correspondence, which means that the photosensitive device 11 has a photosensitivity function.

Therefore, it can be seen that the LDD 1141 included in the semiconductor portion 114 of the photosensitive device 11 and the light-transmitting portion 1111 included in the gate 111 of the photosensitive device 11 may help to improve the photosensitivity of the photosensitive device 11.

With continued reference to FIGS. 5 and 9, the output current Id of the photosensitive device 11 in FIG. 5 is significantly greater than the output current Id of the photosensitive device 11 in FIG. 9 (4.09*10⁻¹¹ A > 7.46*10⁻¹² A); for the gate 111, a light-blocking portion through which light is hard to pass is replaced with the light-transmitting portion 1111, so that the area of the semiconductor portion 114 for receiving ambient light is increased, which allows the ambient light to be more efficiently incident on the semiconductor portion 114 to generate more photosensitive leakage current. Thus, the photosensitive device 11 corresponding to FIG. 9 is more sensitive to ambient light.

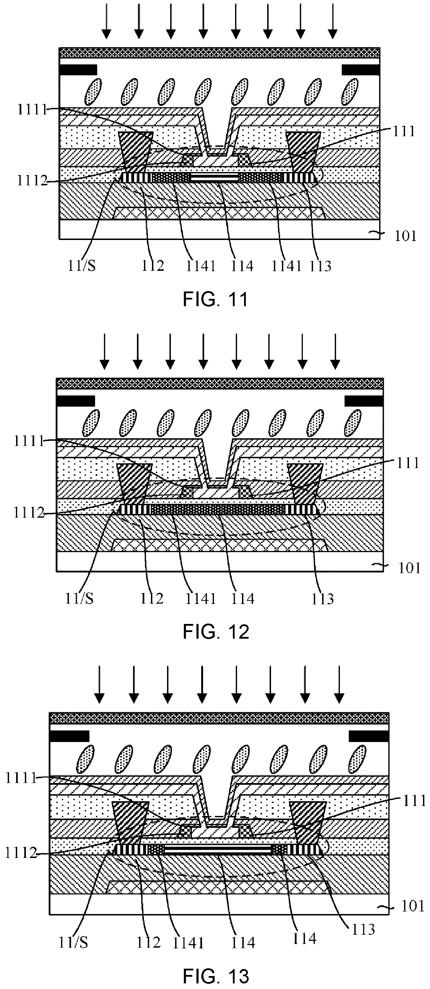

FIG. 11 is a structural diagram of a display substrate, in accordance with still some other embodiments of the present disclosure.

In some embodiments, referring to FIG. 11, in the thickness direction of the display substrate 10, the LDD 1141 overlaps with the gate 111. To be specific, an orthographic projection of the LDD 1141 on the substrate 101 overlaps with the orthographic projection of the gate 111 on the substrate 101. That is, the LDD 1141 is not only located in the first portion, but also extends in a direction approaching the gate 111. In this way, in the extension direction of the substrate 101, a dimension of the LDD 1141 is increased, and correspondingly, an extension area of the LDD 1141 is increased. As a result, the LDD 1141 may further reduce the electric field distribution between the first conductor portion 112 and the semiconductor portion 114 and the electric field distribution between the second conductor portion 113 and the semiconductor portion 114, so as to alleviate the shifting problem of the I-V characteristics due to long-term action caused by the hot carrier effect.

FIG. 12 is a structural diagram of a display substrate, in accordance with still some other embodiments of the present disclosure.

In some embodiments, referring to FIG. 12, in the thickness direction of the display substrate 10, the LDD 1141 covers the gate 111. To be specific, the orthographic projection of the LDD 1141 on the substrate 101 covers the orthographic projection of the gate 111 on the substrate 101. That is, both a portion of the LDD 1141 that is not covered by the gate 111 and a portion of the LDD 1141 that is covered by the light-transmitting portion 1111 may be irradiated by light, so that the area of the LDD structure 1141 for receiving ambient light is increased, which may improve the sensitivity of the photosensitive device 11 to ambient light.

FIG. 13 is a structural diagram of a display substrate, in accordance with still some other embodiments of the present disclosure.

In some embodiments, referring to FIG. 13, in the extension direction of the substrate 101, a dimension of the LDD 1141 is less than or equal to 0.5 um, such as 0.5 um, 0.3 um or 0.2 um. The output current of the photosensitive device 11 is small, and the change of the current is small. Therefore, the measurement precision requirement for the integrated circuit (IC), for example, the sampling circuit, coupled to the photosensitive device 11, is high. In the case where the semiconductor portion 114 is made of low-temperature polycrystalline silicon, the dimension of the LDD 1141 in the extension direction of the substrate 101 has a certain influence on loff. To be specific, in a case where the dimension of the LDD 1141 is less than 0.5 um, loff is exponentially increased as the dimension of the LDD 1141 decreases. Therefore, by limiting the length of the LDD 1141 to be less than 0.5 um, the current change may reach an order of magnitude that the IC can detect.

In some embodiments, the photosensor includes a low-temperature polycrystalline silicon thin film transistor 50 and a photosensitive device 60.

The photosensitive device 60 includes: a semiconductor portion 61 disposed in a same layer as an active layer 51 of the low-temperature polycrystalline silicon thin film transistor 50, a first conductor portion 63 disposed in a same layer as a source 53 of the low-temperature polycrystalline silicon thin film transistor 50, and a second conductor portion 64 disposed in a same layer as a drain 54 of the low-temperature polycrystalline silicon thin film transistor 50. The photosensitive device 60 outputs a photosensitive current in response to an input signal and external light incident on the semiconductor portion, and the low-temperature polycrystalline silicon thin film transistor outputs a reference current in response to an input signal.

In these embodiments, based on the forming process of the low-temperature polycrystalline silicon thin film transistor, the photosensor including the low-temperature polycrystalline silicon thin film transistor 50 and the photosensitive device 60 is formed in the non-display region of the display substrate, and at least part of the photosensitive device 60 is formed synchronously with the low-temperature polycrystalline silicon thin film transistor 50, which means that the photosensitive device 60 is a photosensitive detection device formed based on the low-temperature polycrystalline silicon thin film transistor 50. In other words, the photosensitive device is a photosensitive device obtained by modifying the low-temperature polycrystalline silicon thin film transistor. With the provision the low-temperature polycrystalline silicon thin film transistor and the photosensitive device disposed in the driving circuit layer in the non-display region, the photosensor may achieve an automatic detection for ambient light.

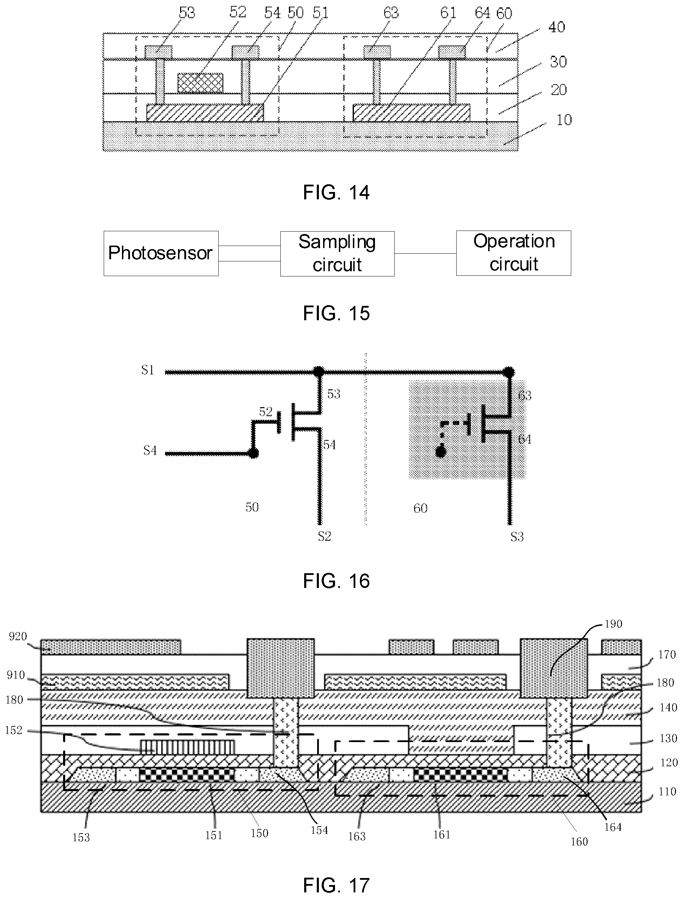

To be specific, the low-temperature polycrystalline silicon thin film transistor of the photosensor outputs a reference current in response to an input signal, and the photosensitive device of the photosensor outputs a photosensitive current in response to an input signal and external light incident on the semiconductor portion of the photosensitive device. As shown in FIG. 14, these embodiments are described with a basic structure of thin film transistor; the display substrate includes the photosensor that outputs a reference current and an output current, and the reference current and the output current differ by at least one order of magnitude; with a detection circuit provided in the display apparatus, such as the detection circuit shown in FIG. 15, a voltage difference corresponding to a current difference between the reference current and the output current may be obtained by the sampling circuit, and based on the voltage difference, illuminance of external light may be obtained by the operation circuit such as an analog-to-digital convertor and a digital operation circuit. In this way, the detection of the illuminance of external ambient light may be achieved.

In these embodiments, based on the forming process of the existing low-temperature polycrystalline silicon thin film transistor, the photosensitive device based on the low-temperature polycrystalline silicon thin film transistor may be fabricated to form the photosensor. That is, the photosensor is formed based on the mask used in the forming process of the existing low-temperature polycrystalline silicon thin film transistor. In this way, the problems existing in the related art may be alleviated, the manufacturing efficiency of the display substrate may be effectively improved, and the manufacturing process may be simplified to reduce cost and increase market competitiveness.

It is worth noting that, the specific structure of the display substrate, the specific structure of the low-temperature polycrystalline silicon thin film transistor, and the specific structure of the photosensitive device are not specifically limited in the present disclosure; the low-temperature polycrystalline silicon thin film transistor may be of a top-gate structure or a bottom-gate structure, and the elements of the photosensitive device may each be the same as or different from a corresponding element of the low-temperature polycrystalline silicon thin film transistor, as long as the design criterion is the detection and measurement of external light by the photosensitive device, which is not repeated here.

In an optional embodiment, the low-temperature polycrystalline silicon thin film transistor is of a top-gate structure, and the gate of the low-temperature polycrystalline silicon thin film transistor is opaque; as shown in FIGS. 14 and 16, the source 53 of the low-temperature polycrystalline silicon thin film transistor 50 and the first conductor portion 63 of the photosensitive device 60 receive a first signal S1, the drain 54 of the low-temperature polycrystalline silicon thin film transistor 50 receives a second signal S2, the second conductor portion 64 of the photosensitive device 60 receive a third signal S3, and the gate 52 of the low-temperature polycrystalline silicon thin film transistor 50 receive a fourth signal S4; in this way, the low-temperature polycrystalline silicon thin film transistor 50 outputs a reference current in response to the input first signal S1, second signal S2 and fourth signal S4, and the photosensitive device 60 outputs a photosensitive current in response to the input first signal S1 and third signal S3 and the external light incident on the semiconductor portion.

To further improve the photosensitivity of the photosensor, in an optional embodiment, the display substrate further includes a black matrix disposed on the driving circuit layer; an orthographic projection of the black matrix on the substrate covers an orthographic projection of the low-temperature polycrystalline silicon thin film transistor on the substrate, and the orthographic projection of the black matrix on the substrate is non-overlapping with an orthographic projection of the photosensitive device on the substrate.

In this embodiment, considering that the low-temperature polycrystalline silicon thin film transistor is easily affected by external light and other light in the display substrate and thus the reliability of the reference current is affected, the black matrix located above the driving circuit layer and located in the array substrate structure is used to cover the low-temperature polycrystalline silicon thin film transistor, so as to ensure that the low-temperature polycrystalline silicon thin film transistor outputs a reference current suitable for reference based on the input signals, thereby effectively improving the accuracy and sensitivity of the photosensor.

It is worth noting that, the specific position of the photosensor is not limited in the present disclosure, and the photosensor may be located at any position in the non-display region where the photosensor can receive light; for example, as shown in FIG. 3a, the photosensor is located at the upper of the display substrate and includes the low-temperature polycrystalline silicon thin film transistor 50 and the photosensitive device 60; alternatively, as shown in FIG. 3b, the photosensor is located at the side of the display substrate and includes the low-temperature polycrystalline silicon thin film transistor 50 and the photosensitive device 60.

**In** an optional embodiment, based on the provision of the black matrix, the semiconductor portion of the photosensitive device and the active layer of the low-temperature polycrystalline silicon thin film transistor have a same size, the first conductor portion of the photosensitive device and the source of the low-temperature polycrystalline silicon thin film transistor have a same size, the second conductor portion of the photosensitive device and the drain of the low-temperature polycrystalline silicon thin film transistor have a same size, and the input second signal and third signal are the same. **In** this case, the difference between the reference current and the photosensitive current is caused by the case that the external light incident on the semiconductor portion.

**In** a specific embodiment, as shown in FIG. 17, the display substrate includes:
a semiconductor layer that is patterned and disposed on a substrate 110; the semiconductor layer including an active layer 151, a source 153 and a drain 154 of a low-temperature polycrystalline silicon thin film transistor 150, and a semiconductor portion 161, a first conductor portion 163 and a second conductor portion 164 of a photosensitive device 160; the source 153, the drain 154, the first conductor portion 163 and the second conductor portion 164 being formed from a semiconductor material of the semiconductor layer by conductorization;
a gate insulating layer 120 covering the semiconductor layer and an exposed portion of the substrate 110;
a gate 151 of the low-temperature polycrystalline silicon thin film transistor 150 disposed on the gate insulating layer 120;
an interlayer insulating layer 130 covering the gate 151 and an exposed portion of the gate insulating layer 120; the interlayer insulating layer 130 including a plurality of first via holes extending to the drain 154 and the second conductor portion 264;
a plurality of first auxiliary conductor portions 180 that are patterned are disposed on the interlayer insulating layer 130 for receiving an input signal, and each first via hole is filled with a corresponding first auxiliary conductor portion 180; and
a planarization layer 140 disposed on the interlayer insulating layer 130 and surrounding the first auxiliary conductor portion 180.

In this embodiment, the photosensitive device based on the low-temperature polycrystalline silicon semiconductor is formed based on the fabricating process of the low-temperature polycrystalline silicon thin film transistor in the driving circuit layer; the photosensitive device 160 includes the semiconductor portion 161 formed synchronously with the active layer 151 of the low-temperature polycrystalline silicon thin film transistor 150, the first conductor portion 163 formed synchronously with the source 153 of the low-temperature polycrystalline silicon thin film transistor 150, and the second conductor portion 164 formed synchronously with the drain 154 of the low-temperature polycrystalline silicon thin film transistor 150. That is, the photosensitive device 160 is a low-temperature polycrystalline silicon thin film transistor in which the gate removed, which means that the photosensitive device capable of detecting light may be formed by modifying the low-temperature polycrystalline silicon thin film transistor in the fabricating process. The display substrate in this embodiment may be applied to various display products with an automatic ambient light detection function, and has practical application prospects.

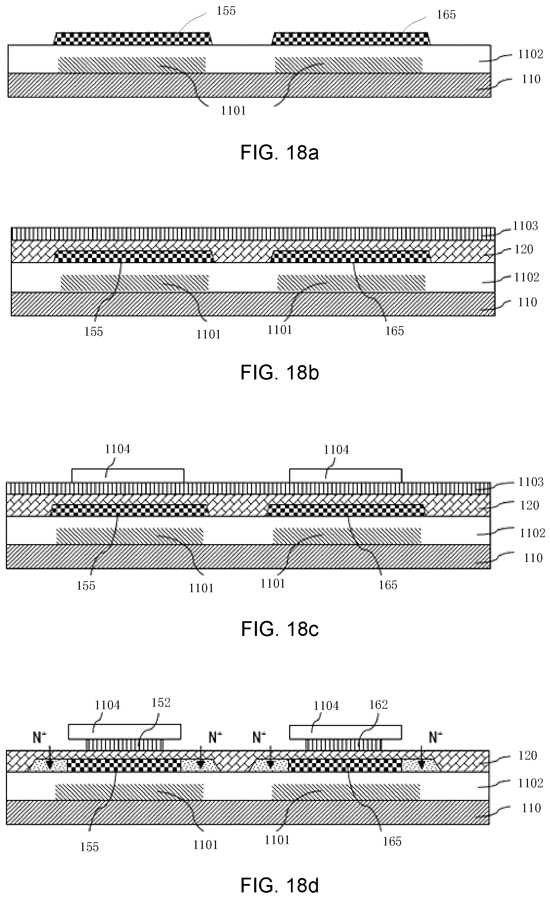

In a specific embodiment, a specific manufacturing process of the display substrate is described below by taking an example in which the display substrate is applied to a liquid crystal display panel, referring to FIGS. 18a to 18n, the manufacturing process includes the following steps.

As shown in FIG. 18a, a semiconductor layer that is patterned is formed on a substrate, and the semiconductor layer includes a semiconductor structure of the low-temperature polycrystalline silicon thin film transistor and a semiconductor structure of the photosensitive device.

In this embodiment, considering that the liquid crystal display panel includes a backlight source, in order to prevent the light emitted by the backlight source from affecting the semiconductor layer made of low-temperature polycrystalline silicon, a light-blocking layer 1101 that is patterned is formed on the substrate by using a mask, a buffer layer 1102 covering the light-blocking layer and an exposed portion of the substrate is formed, and the semiconductor layer made of low-temperature polycrystalline silicon is formed on the buffer layer 1102. The semiconductor layer includes the semiconductor structure 155 of the low-temperature polycrystalline silicon thin film transistor and the semiconductor structure 165 of the photosensitive device.

As shown in FIGS. 18b to 18f, a gate insulating layer covering the semiconductor layer and the exposed portion of the substrate is formed, and a gate layer that is patterned is formed on the gate insulating layer; the gate layer includes a gate of the low-temperature polycrystalline silicon thin film transistor and a gate portion of the photosensitive device; the semiconductor layer is conductorized, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate covers an orthographic projection of the active layer on the substrate, and an orthographic projection of the gate portion of the photosensitive device on the substrate covers an orthographic projection of the semiconductor portion on the substrate.

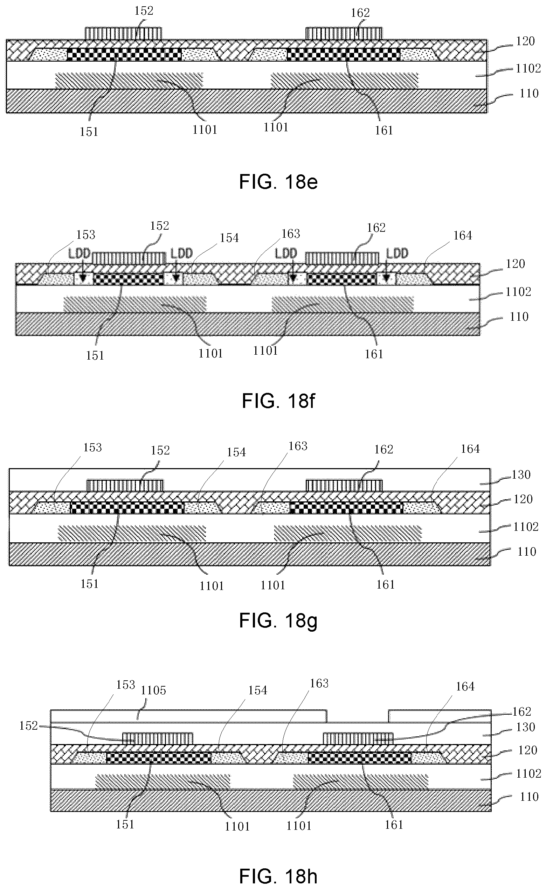

In this embodiment, as shown in FIG. 18b, a gate material layer 1103 is formed on the gate insulating layer 120; as shown in FIG. 18c, photoresist 1104 that is patterned is formed on the gate material layer 1103; as shown in FIG. 18d, the gate 152 of the low-temperature polycrystalline silicon thin film transistor and the gate portion 162 of the photosensitive device are formed by etching; the semiconductor structure 155 of the low-temperature polycrystalline silicon thin film transistor and the semiconductor structure 165 of the photosensitive device are conductorized with the shielding of the photoresist 1104; that is, an N-type doping is performed on portions of the semiconductor structures that are not covered by the photoresist 1104 with ions; as shown in FIG. 18e, the photoresist 1104 is removed; as shown in FIG. 18f, the semiconductor structure 155 of the low-temperature polycrystalline silicon thin film transistor and the semiconductor structure 165 of the photosensitive device are conductorized with the shielding of the gate 152 and the gate portion 162; that is, LDDs are formed by performing a second doping process on portions of the semiconductor structures that are not covered by the gate 152 and the gate portion 162, so as to form the active layer 151, the source 153 and the drain 154 of the low-temperature polycrystalline silicon thin film transistor, and the semiconductor portion 161, the first conductor portion 163 and the second conductor portion 164 of the photosensitive device.

As shown in FIGS. 18g to 18j, an interlayer insulating layer that is patterned is formed by using a semi-transparent mask, and the semi-transparent mask has different transmittances corresponding to the gate of the low-temperature polycrystalline silicon thin film transistor and the gate portion of the photosensitive device respectively; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate; the gate portion of the photosensitive device is removed by etching to expose the gate insulating layer.

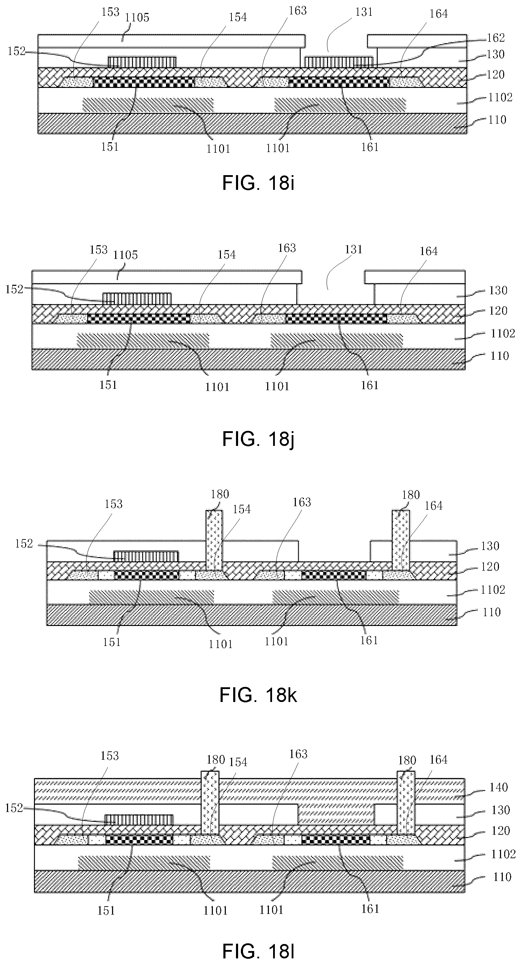

In this embodiment, as shown in FIG. 18g, an interlayer insulating material layer is formed on the gate 152, the gate portion 162 and the exposed portion of the gate insulating layer 120; as shown in FIG. 18h, photoresist 1105 is formed on the interlayer insulating material layer using a semi-transparent mask, and the semi-transparent mask has different transmittances corresponding to the gate of the low-temperature polycrystalline silicon thin film transistor and the gate portion of the photosensitive device respectively; for example, the transmittance at the position corresponding to the gate portion is 0, while the transmittance at other positions is 100%; as shown in FIG. 18i, a via hole 131 penetrating the interlayer insulating material layer is formed by etching to expose the gate portion 162 and form an interlayer insulating layer 130; as shown in FIG. 18j, the gate portion 162 is removing by etching. That is, in this embodiment, the gate portion 162 is removed by using a semi-transparent mask, and based on the fabricating process of the low-temperature polycrystalline silicon thin film transistor, the gate portion is removed based on the formed semiconductor portion, first conductor portion and second conductor portion of the photosensitive device, thereby avoiding the influence on the photosensitivity of semiconductor portion, made of low-temperature polycrystalline silicon, of the photosensitive device due to the opaque gate of the top-gate low-temperature polycrystalline silicon thin film transistor; in other words, the photosensitive device is a device with the gate removed that is formed based on the fabricating process of the low-temperature polycrystalline silicon thin film transistor, i.e., a device capable of detecting light formed based on the low-temperature polycrystalline silicon thin film transistor.

As shown in FIGS. 18k to 18l, a plurality of first via holes extending to the drain and the second conductor portion are formed in the interlayer insulating layer; a plurality of first auxiliary conductor portions that are patterned are formed in the interlayer insulating layer, and each first via hole is filled with a corresponding first auxiliary conductor portion; a planarization layer is formed on the interlayer insulating layer and the exposed portion of the gate insulating layer, and the planarization layer surrounds the first auxiliary conductor portion.

In this embodiment, as shown in FIG. 18k, a plurality of first via holes are formed in the interlayer insulating layer 130, and a plurality of first auxiliary conductor portions 180 that are in one-to-one correspondence with the first via holes are formed on the interlayer insulating layer by using a mask, and each first via hole is filled with a corresponding first auxiliary conductor portion; that is, a first auxiliary conductor portion 180 connected to the drain 154 is connected to the drain, and another first auxiliary conductor portion 180 connected to the second conductor portion 164 is connected to the second conductor portion; as shown in FIG. 18l, a planarization layer 140 is formed on the interlayer insulating layer 130 by using a mask, and a via hole penetrating the interlayer insulating layer 130 and extending to the gate insulating layer 120 is filled with the planarization layer 140; that is, the space occupied by the original gate portion is filled with the planarization layer, and the planarization layer 140 surrounds each first auxiliary conductor portion 180.

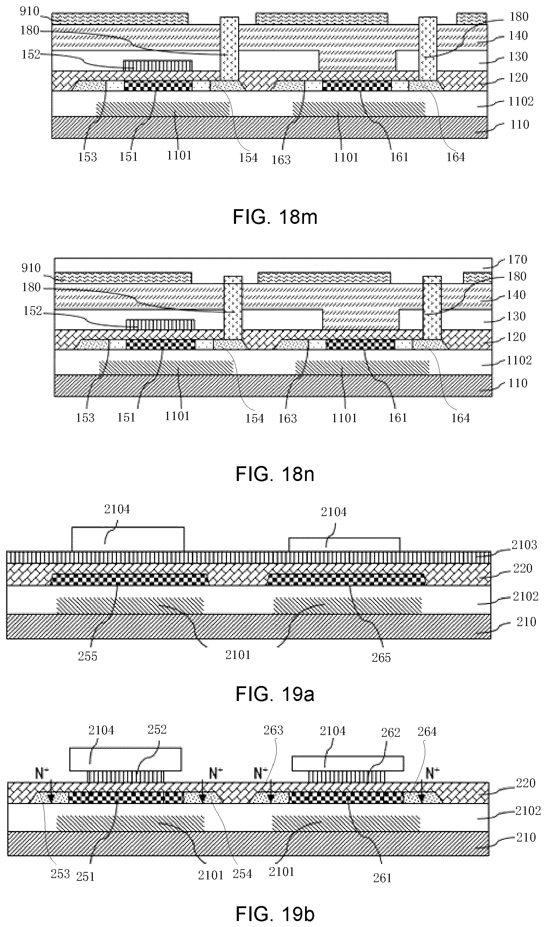

As shown in FIG. 18m, a common electrode that is patterned is formed on the planarization layer, and an orthographic projection of the common electrode on the substrate is non-overlapping with orthographic projections of the first auxiliary conductor portions on the substrate.

In this embodiment, a common electrode 910 of the liquid crystal display panel is formed on the planarization layer 140 by using a mask; considering that one of the first auxiliary conductor portions 180 needs to receive a second signal to the drain 154 of the low-temperature polycrystalline silicon thin film transistor and another one of the first auxiliary conductor portions needs to receive a third signal to the second conductor portion 164 of the photosensitive device, the orthographic projection of the common electrode 910 on the substrate is non-overlapping with the orthographic projections of the first auxiliary conductor portions 180 on the substrate.

As shown in FIGS. 18n and 17, a passivation layer is formed on the common electrode and an exposed portion of the planarization layer, and the passivation layer includes a plurality of second via holes extending to the first auxiliary conductor portions; orthographic projections of the second via holes on the substrate cover the orthographic projections of the first auxiliary conductor portions on the substrate; pixel electrodes and a plurality of second auxiliary conductor portions that are both patterned are formed on the passivation layer, each second via hole is filled with a corresponding second auxiliary conductor portion, and the second auxiliary conductor portions are connected to the drain and the second conductor portion respectively through the respective first auxiliary conductor portions.

In this embodiment, as shown in FIG. 18n, a passivation layer 170 covering the common electrode is further formed; considering that the second signal and the third signal are need to be input to the first auxiliary conductor portions, via holes are formed in the passivation layer and each extend to a respective first auxiliary conductor portion; as shown in FIG. 17, a plurality of second auxiliary conductor portions 190 that are in one-to-one correspondence with the via holes and the pixel electrodes 920 are formed on the passivation layer, and the second auxiliary conductor portions are arranged in the same layer as the pixel electrodes; that is, a second auxiliary conductor portion for receiving the second signal to the drain of the low-temperature polycrystalline silicon thin film transistor is formed based on the fabricating process of the pixel electrodes, another second auxiliary conductor portion for receiving the third signal to the second conductor portion of the photosensitive device is formed based on the fabricating process of the pixel electrodes, and the second auxiliary conductor portions are connected to the first auxiliary conductor portions in one-to-one correspondence, so as to transmit the second signal and the third signal to the drain and the second conductor portion, respectively.

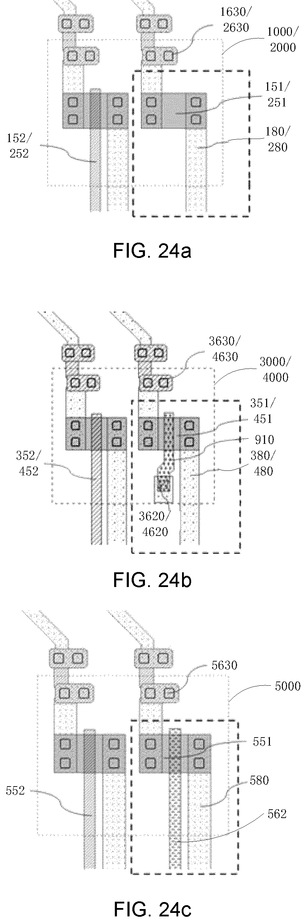

In this way, a photosensor 1000 of the display substrate as shown in FIG. 17 is formed. In this embodiment, by using the fabricating process of the existing low-temperature polycrystalline silicon thin film transistor, the interlayer insulating layer is formed using the semi-transparent mask based on the formed semiconductor portion, first conductor portion and second conductor portion of the photosensitive device; as shown in FIG. 24a, the low-temperature polycrystalline silicon thin film transistor including the gate 152 is at the left side of the photosensor 1000, the photosensitive device with the gate portion removed is at the right side of the photosensor 1000, and the photosensitive device includes only the semiconductor portion and the conductorized first conductor portion and second conductor portion; the first conductor portion may receive the first signal through a via hole 1630, and the second conductor portion may receive the third signal through the first auxiliary conductor portion 180. In this way, it is possible to avoid the problem that the light cannot be detected due to the shielding of the gate of the top-gate low-temperature polycrystalline silicon thin film transistor, thereby realizing a photosensitive device based on a low-temperature polycrystalline silicon thin film transistor.

In another specific example, a specific manufacturing process of the display substrate is described below by still taking an example in which the display substrate is applied to the liquid crystal display panel, referring to FIGS. 19a to 19f, the manufacturing process includes the following steps.

As shown in FIGS. 19a to 19f, a semiconductor layer that is patterned is formed on a substrate, and the semiconductor layer includes a semiconductor structure of the low-temperature polycrystalline silicon thin film transistor and a semiconductor structure of the photosensitive device; a gate insulating layer covering the semiconductor layer and an exposed portion of the substrate is formed; a gate layer that is patterned is formed on a gate insulating layer by using a semi-transparent mask; the gate layer includes a gate of the low-temperature polycrystalline silicon thin film transistor and a gate portion of the photosensitive device, and the semi-transparent mask has different transmittances corresponding to the gate of the low-temperature polycrystalline silicon thin film transistor and the gate portion of the photosensitive device respectively. The semiconductor layer is subjected to a first conductorization process, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate covers an orthographic projection of the active layer on the substrate, and an orthographic projection of the gate portion of the photosensitive device on the substrate covers an orthographic projection of the semiconductor portion on the substrate; the gate portion of the photosensitive device is removed by etching to expose the gate insulating layer; and the semiconductor layer is subjected to a second conductorization process.

In this embodiment, considering that the liquid crystal display panel includes a backlight source, in order to prevent the light emitted by the backlight source from affecting the semiconductor layer made of low-temperature polycrystalline silicon, by using a mask, a light-blocking layer 2101 is patterned and formed on the substrate, a buffer layer 2102 covering the light-blocking layer and an exposed portion of the substrate is formed, and the semiconductor layer made of low-temperature polycrystalline silicon is formed on the buffer layer 2102. The semiconductor layer includes the semiconductor structure 255 of the low-temperature polycrystalline silicon thin film transistor and the semiconductor structure 265 of the photosensitive device.

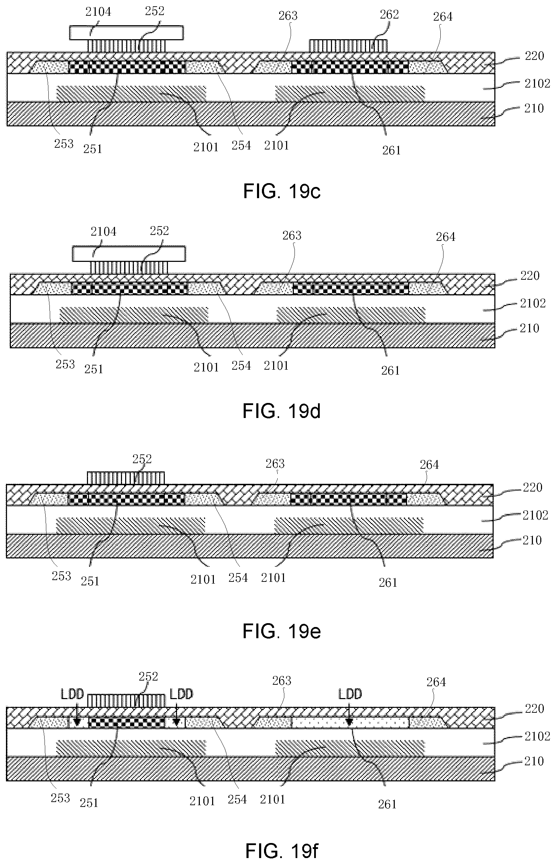

Then, as shown in FIG. 19a, a gate material layer 2103 is formed on the gate insulating layer 220, and photoresist 2104 is patterned on the gate material layer 2103 by using a semi-transparent mask; the photoresist has different thicknesses at different positions; for example, at a position corresponding to the low-temperature polycrystalline silicon thin film transistor, the photoresist is thick, and the transmittance of the semi-transparent mask is 100%; while at a position corresponding to the photosensitive device, the photoresist is thin, and the transmittance of the semi-transparent mask is 50%; as shown in FIG. 19b, the gate 252 of the low-temperature polycrystalline silicon thin film transistor and the gate portion 262 of the photosensitive device are formed by etching, and the semiconductor structure 255 of the low-temperature polycrystalline silicon thin film transistor and the semiconductor structure 265 of the photosensitive device are conductorized with the shielding of the photoresist 2104; that is, an first N-type doping is performed on portions of the semiconductor structures that are not covered by the photoresist 2104 with ions to form the active layer 251, the source 253 and the drain 254 of the low-temperature polycrystalline silicon thin film transistor, as well as the semiconductor portion 261, the first conductor portion 263 and the second conductor portion 264 of the photosensitive device; as shown in FIG. 19c, a portion of the photoresist 2104 is removed; that is, a portion of the photoresist 2104 covering the gate 252 of the low-temperature polycrystalline silicon thin film transistor is thinned, and another portion of the photoresist covering the gate portion 262 of the photosensitive device is removed; as shown in FIG. 19d, the gate portion of the photosensitive device is removed, and the gate 252 of the low-temperature polycrystalline silicon thin film transistor is not affected due to the protection of the photoresist 2104; as shown in FIG. 19e, the photoresist 2104 on the gate 252 is removed; as shown in FIG. 19f, a second conductorization process is performed; that is, LDDs are formed at a position between the source and the active layer and a position between the drain and the active layer by a second doping process, and the semiconductor portion of the photosensitive structure is an LDD formed by doping, which may further improve the sensitivity of the photosensitive device to external light. For example, in a case where external light is incident on the photosensitive device with the LDD, the photosensitive current may be increased, so that the difference between the photosensitive current and the reference current is great, which is easier to be sampled by a sampling circuit at back-end and detected by a operation circuit at back-end. In this way, the accuracy and sensitivity of the photosensor is improved.

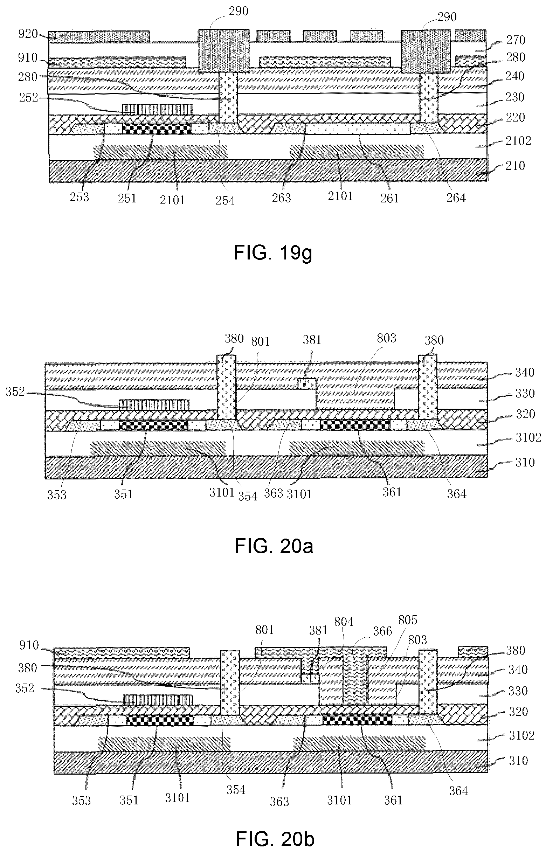

As shown in FIG. 19g, an interlayer insulating layer is formed on the gate and an exposed portion of the gate insulating layer, and the interlayer insulating layer includes a plurality of first via holes extending to the drain and the second conductor portion; a plurality of first auxiliary conductor portions that are patterned are formed on the interlayer insulating layer, and each first via hole is filled with a corresponding first auxiliary conductor portion; a planarization layer is formed on the interlayer insulating layer, and the planarization layer surrounds the first auxiliary conductor portion; a common electrode that is patterned is formed on the planarization layer, and an orthographic projection of the common electrode on the substrate is non-overlapping with orthographic projections of the first auxiliary conductor portions on the substrate; a passivation layer is formed on the common electrode and an exposed portion of the planarization layer, and the passivation layer includes a plurality of second via holes extending to the first auxiliary conductor portions; orthographic projections of the second via holes on the substrate cover the orthographic projections of the first auxiliary conductor portions on the substrate; pixel electrodes and a plurality of second auxiliary conductor portions that are both patterned are formed on the passivation layer, each second via hole is filled with a corresponding second auxiliary conductor portion, and the second auxiliary conductor portions are connected to the drain and the second conductor portion respectively through respective first auxiliary conductor portions.

In this embodiment, the interlayer insulating layer 230 is formed on the gate 251 and the exposed portion of the gate insulating layer 220; the interlayer insulating layer 230 includes the plurality of first via holes; the plurality of first auxiliary conductor portions 280 that are patterned are formed on the interlayer insulating layer 230, the plurality of first auxiliary conductor portions 280 are in one-to-one correspondence with the plurality of first via holes, and each first via hole is filled with a respective first auxiliary conductor portion 280; then, the planarization layer 240 that is patterned is formed on the interlayer insulating layer 280, and the planarization layer 240 surrounds the first auxiliary conductor portion 280; the common electrode 910 that is patterned is formed on the planarization layer 240; considering that one of the first auxiliary conductor portions 280 needs to receive the second signal to the drain 254 of the low-temperature polycrystalline silicon thin film transistor and another one of the first auxiliary conductor portions needs to receive the third signal to the second conductor portion 264 of the photosensitive device, the orthographic projection of the common electrode 910 on the substrate is non-overlapping with the orthographic projections of the first auxiliary conductor portions 280 on the substrate; then, the passivation layer 270 covering the common electrode is formed; considering that the second signal and the third signal are need to be input to the first auxiliary conductor portions, via holes are formed in the passivation layer 270 and each extends to a respective first auxiliary conductor portion 280; a plurality of second auxiliary conductor portions 290 that are in one-to-one correspondence with the via holes and pixel electrodes 920 are formed on the passivation layer 270, and the second auxiliary conductor portions 290 are arranged in the same layer as the pixel electrodes 920; that is, a second auxiliary conductor portion for receiving the second signal to the drain 254 of the low-temperature polycrystalline silicon thin film transistor is formed by the fabricating process of the pixel electrodes 920, another second auxiliary conductor portion for receiving the third signal to the second conductor portion 264 of the photosensitive device is formed based on the fabricating process of the pixel electrodes 920, and the second auxiliary conductor portions are connected to the first auxiliary conductor portions in one-to-one correspondence, so as to transmit the second signal and the third signal to the drain and the second conductor portion, respectively.

In this way, a photosensor 2000 of the display substrate as shown in FIG. 19g is formed. In this embodiment, by using the fabricating process of the existing low-temperature polycrystalline silicon thin film transistor, the gate is formed using the semi-transparent mask, and based on that the semiconductor structures are conductorized, the gate portion of the photosensitive device is removed and the semiconductor portion of the photosensitive device is conductorized; as shown in FIG. 24a, the low-temperature polycrystalline silicon thin film transistor including the gate 252 is at the left side of the photosensor 2000, the photosensitive device with the gate portion removed is at the right side of the photosensor, and the photosensitive device includes the semiconductor portion and the conductorized first conductor portion and second conductor portion; the first conductor portion may receive the first signal through a via hole 2630, and the second conductor portion may receive the third signal through the first auxiliary conductor portion 280. In this way, it is possible to avoid the problem that the light cannot be detected due to the shielding of the gate of the top-gate low-temperature polycrystalline silicon thin film transistor, thereby realizing a photosensitive device based on a low-temperature polycrystalline silicon thin film transistor; furthermore, it is possible to improve the sensitivity of the photosensitive device to external light, thereby improving the accuracy and sensitivity of the photosensor.

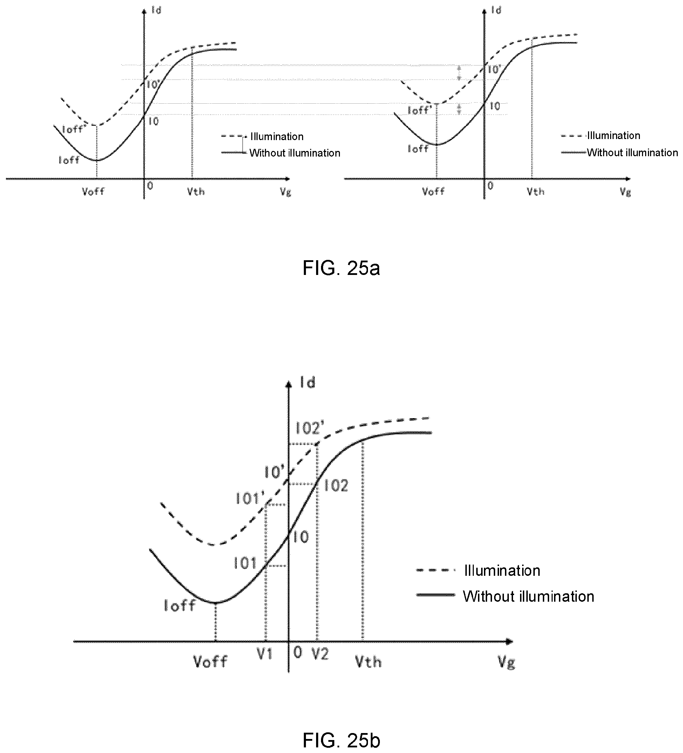

FIG. 25a is a comparative diagram of photosensitive currents output by the photosensors in the above two embodiments under condition without illumination and under condition of illumination; in this figure, the axis x represents the voltage Vg, the axis y represents the current Id, the left-side chart in FIG. 25a represents the photosensor 1000, and the right-side chart in FIG. 25a represents the photosensor 2000. As can be seen from this figure, compared with the condition of without illumination, the photosensitive current output by the photosensor 1000 is increased under illumination; that is, the photosensitive current output by the photosensor in response to detecting external light is increased; similarly, compared with the condition of without illumination, the photosensitive current output by the photosensor 2000 is also increased under illumination. As can be seen from the comparison of the two charts, since the semiconductor portion of the photosensitive device of the photosensor 2000 is doped, the photosensitive current output by the photosensor 2000 is greater than that output by the photosensor 1000 under the condition of without illumination; that is, the photosensitive current output by the photosensor 2000 is greater than that output by the photosensor 1000 under the same ambient light illumination condition, which means that the photosensitive current output by the photosensor 2000 is easier to be detected by the sampling circuit and operation circuit at the back-end.

In the display substrates as shown in FIGS. 17 and 19g, considering that the photosensitive device is in a uncertain-level state after the removal of the gate portion, which affects the controllability of the output photosensitive current, in an optional embodiment, the photosensitive device is a thin film transistor, the semiconductor portion of the photosensitive device is an active layer, the first conductor portion of the photosensitive device is a source, and the second conductor portion of the photosensitive device is a drain; the gate of the photosensitive device is made of a transparent material; the gate of the photosensitive device receives a fifth signal, and the photosensitive device outputs a photosensitive current in response to the first signal, the third signal, the fifth signal, and the external light incident on the semiconductor portion.

In this embodiment, the photosensitive device is a low-temperature polycrystalline silicon thin film transistor with a transparent gate; that is, the photosensitive device is a complete thin film transistor, and the transparent gate receives the fifth signal, so that the photosensitive current output by the photosensor may be concentrated within a certain range; that is, the output photosensitive current changes with the voltage change of the fifth signal received by the gate. In a case where the reference current output by the low-temperature polycrystalline silicon thin film transistor of the photosensor remains unchanged and the difference between the reference current and the photosensitive current is too large or too small, the current difference may be adjusted and controlled by adjusting the signal transmitted to the transparent gate of the photosensitive device, so that the value of the current difference is set within a range that can be easily detected, and decrease in the measurement accuracy and sensitivity due to excessive sensitivity to light may be avoided. As a result, the measurement precision of the photosensor may be further improved based on the fabricating process of the low-temperature polycrystalline silicon thin film transistor.

In a specific embodiment, a specific manufacturing process of the display substrate is described below by taking an example in which the display substrate is applied to the liquid crystal display panel, referring to FIGS. 20a to 20c, the manufacturing process includes the following steps.

As shown in FIG. 20a, a semiconductor layer that is patterned is formed on a substrate 310, and the semiconductor layer includes a semiconductor structure of the low-temperature polycrystalline silicon thin film transistor and a semiconductor structure of the photosensitive device; a gate insulating layer 320 covering the semiconductor layer and an exposed portion of the substrate 310 is formed; a gate layer that is patterned is formed on the gate insulating layer 320, and the gate layer includes a gate 352 of the low-temperature polycrystalline silicon thin film transistor and a gate portion of the photosensitive device; the semiconductor layer is conductorized, so that the semiconductor structure of the low-temperature polycrystalline silicon thin film transistor is formed into an active layer 351, and a source 353 and a drain 354 respectively disposed on two sides of the active layer, and the semiconductor structure of the photosensitive device is formed into a semiconductor portion 361, a first conductor portion 363 and a second conductor portion 364; an orthographic projection of the gate 352 of the low-temperature polycrystalline silicon thin film transistor on the substrate 310 covers an orthographic projection of the active layer 351 on the substrate 310, and an orthographic projection of the gate portion of the photosensitive device on the substrate covers an orthographic projection of the semiconductor portion on the substrate; an interlayer insulating layer 330 that is patterned is formed using a semi-transparent mask, and the semi-transparent mask has different transmittances corresponding to the gate 352 of the low-temperature polycrystalline silicon thin film transistor and the gate portion of the photosensitive device respectively; an orthographic projection of the interlayer insulating layer 330 on the substrate 310 covers the orthographic projection of the gate 352 of the low-temperature polycrystalline silicon thin film transistor on the substrate 310, and the interlayer insulating layer 330 partially covers an exposed portion of the gate insulating layer 320; the orthographic projection of the interlayer insulating layer 330 on the substrate 310 is non-overlapping with the orthographic projection of the gate portion of the photosensitive device on the substrate; the gate portion of the photosensitive device is removed by etching to expose the gate insulating layer; a plurality of first via holes 801 extending to the drain and the second conductor portion are formed in the interlayer insulating layer, and a third via hole 803 extending to the gate insulating layer is formed in the interlayer insulating layer; a plurality of first auxiliary conductor portion 380 and a third auxiliary conductor portion 381 that are patterned are formed on the interlayer insulating layer, and each first via hole 801 is filled with a corresponding first auxiliary conductor portion 380; a planarization layer 340 is formed on the interlayer insulating layer 330, the third auxiliary conductor portion 381 and a portion of the gate insulating layer 320 exposed by the third via hole 803; the planarization layer 340 surrounds the first auxiliary conductor portion 380, and the third via hole is filled with the planarization layer 340.

Considering that the liquid crystal display panel includes a backlight source, in this embodiment, the display substrate further includes a light-blocking layer and a buffer layer that are disposed on a side of the substrate proximate to the semiconductor layer. Based on the fabricating process of the low-temperature polycrystalline silicon thin film transistor and the forming process of the semiconductor portion, first conductor portion and second conductor portion of the photosensitive device, the gate portion of the photosensitive device is removed by using a semi-transparent mask in the process of forming the interlayer insulating layer; a plurality of via holes are formed in the interlayer insulating layer; the plurality of via holes include: the first via holes that are filled with the first auxiliary conductor portions to be connected to the drain and the second conductor portion, and the third via hole that is filled with the planarization layer, i.e., the space remained after the gate portion is removed. The specific process is similar to that in the aforementioned embodiments, which will not be elaborated here.

As shown in FIG. 20b, a fourth via hole 804 extending to the third auxiliary conductor portion 381 and a fifth via hole 805 extending to the gate insulating layer 320 are formed in the planarization layer 340; an orthographic projection of the fifth via hole 805 on the substrate 310 is located within an orthographic projection of the semiconductor portion 361 of the photosensitive device on the substrate 310, and the orthographic projection of the fifth via hole 805 on the substrate 310 is located within an orthographic projection of the third via hole 803 on the substrate 310; a common electrode 910 that is patterned and a gate 366 of the photosensitive device are formed on the planarization layer; an orthographic projection of the common electrode 910 on the substrate 310 is non-overlapping with orthographic projections of the first auxiliary conductor portions 380 on the substrate 310; the fourth via hole 804 and the fifth via hole 805 are filled with the gate 366 of the photosensitive device, and the gate 366 of the photosensitive device is connected to the third auxiliary conductor portion 381.

In this embodiment, the gate of the photosensitive device is connected to the third auxiliary conductor portion through the fourth via hole formed in the planarization layer, and the gate of the photosensitive device is disposed above the semiconductor portion through the fifth via hole. In this way, the gate, for example, made of indium tin oxide (ITO) and arranged in the same layer as the common electrode, of the photosensitive device may receive the fifth signal through the third auxiliary conductor portion to control the photosensitive current generated by the photosensitive device in response to detecting external light.

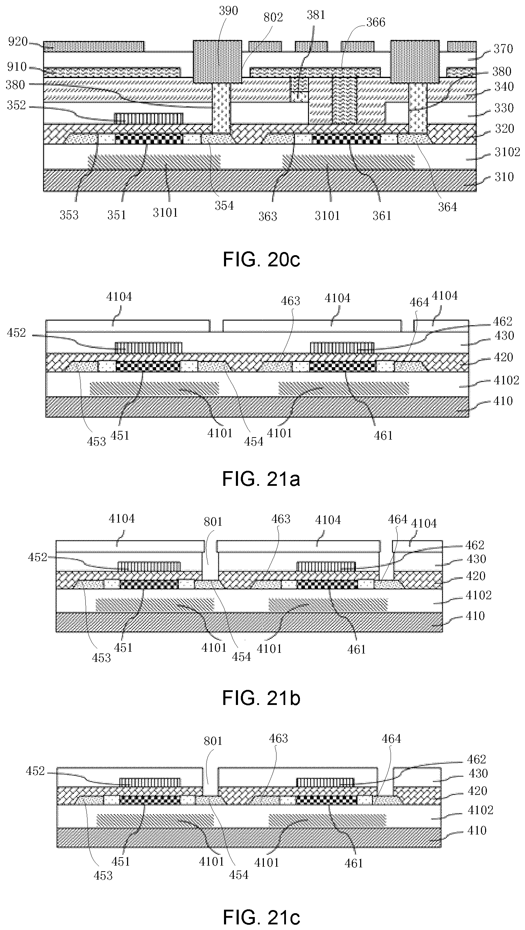

As shown in FIG. 20c, a passivation layer 370 covering the common electrode 910 and the gate 366 of the photosensitive device is formed; the passivation layer 370 includes a plurality of second via holes 802 each extending to a respective first auxiliary conductor portion 380; pixel electrodes 920 that are patterned and a plurality of second auxiliary conductor portion 390 are formed on the passivation layer 370; each second via hole 802 is filled with a respective second auxiliary conductor portion 390, and the second auxiliary conductor portions 390 are connected to the drain 354 and the second conductor portion 364 respectively through respective first auxiliary conductor portions 380.

In this way, a photosensor 3000 of the display substrate as shown in FIG. 20c is formed; to be specific, the photosensor includes the patterned semiconductor layer on the substrate; the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from the semiconductor material of the semiconductor layer by conductorization; the photosensor further includes: the gate insulating layer covering the semiconductor layer and the exposed portion of the substrate, the gate of the low-temperature polycrystalline silicon thin film transistor disposed on the gate insulating layer, and the interlayer insulating layer covering the gate and the exposed portion of the gate insulating layer; the interlayer insulating layer includes the plurality of first via holes extending to the drain and the second conductor portion and includes the third via hole extending to the gate insulating layer; the photosensor further includes the plurality of patterned first auxiliary conductor portions and the patterned third auxiliary conductor portion disposed on the interlayer insulting layer, and each first via hole is filled with a respective first auxiliary conductor portion; the photosensor further includes the planarization layer that is disposed on the interlayer insulating layer, the third auxiliary conductor portion and the exposed portion of the gate insulting layer and that surrounding the first auxiliary conductor portion, and the planarization layer includes the fourth via hole extending to the third auxiliary conductor portion and the fifth via hole extending to the gate insulating layer; the orthographic projection of the fifth via hole on the substrate is located within the orthographic projection of the semiconductor portion of the photosensitive device on the substrate, and the orthographic projection of the fifth via hole on the substrate is located within the orthographic projection of the third via hole on the substrate; the photosensor further includes the patterned gate of the photosensitive device disposed on the planarization layer, and the fourth via hole and the fifth via hole are filled with the gate of the photosensitive device, and the gate of the photosensitive device is connected to the third auxiliary conductor portion through the fourth via hole.

In this embodiment, based on the fabricating process of the existing low-temperature polycrystalline silicon thin film transistor and the forming process of the semiconductor portion, first conductor portion and second conductor portion of the photosensitive device, the gate portion of the photosensitive device is removed, and the interlayer insulating layer is formed using the semi-transparent mask; as shown in FIG. 24b, the low-temperature polycrystalline silicon thin film transistor including the gate 352 is at the left side of the photosensor 3000, the photosensitive device including the transparent gate is at the right side, and the photosensitive device further includes the semiconductor portion and the conductorized first conductor portion and second conductor portion; the first conductor portion may receive the first signal through a via hole 3630, the second conductor portion may receive the third signal through the first auxiliary conductor portion 380, and the gate of the photosensitive device may receive the fifth signal through a via hole 3630. In this way, the problem that the light cannot be detected due to the shielding of the gate of the top-gate low-temperature polycrystalline silicon thin film transistor may be avoided. Besides, the transparent gate of the photosensitive device is formed synchronously with the common electrode, and the transparent gate receives the fifth signal through the third auxiliary conductor portion, so that the photosensitive current output by the photosensitive device may be controlled. As a result, the photosensitive device based on the low-temperature polycrystalline silicon thin film transistor is realized.

In another specific embodiment, a specific manufacturing process of the display substrate is described below by still taking an example in which the display substrate is applied to the liquid crystal display panel, referring to FIGS. 21a to 21n, the manufacturing process includes the following steps.

As shown in FIG. 21a, a semiconductor layer that is patterned is formed on a substrate 410, and the semiconductor layer includes a semiconductor structure of the low-temperature polycrystalline silicon thin film transistor and a semiconductor structure of the photosensitive device; a gate insulating layer 420 covering the semiconductor layer and an exposed portion of the substrate 410 is formed; a gate layer that is patterned is formed on the gate insulating layer, and the gate layer includes a gate 452 of the low-temperature polycrystalline silicon thin film transistor and a gate portion 462 of the photosensitive device; the semiconductor layer is conductorized, such that the semiconductor structure of the low-temperature polycrystalline silicon thin film transistor is formed into an active layer 451, and a source 453 and a drain 454 respectively disposed on two sides of the active layer, and the semiconductor structure of the photosensitive device is formed into a semiconductor portion 461, a first conductor portion 463 and a second conductor portion 464; an orthographic projection of the gate 452 of the low-temperature polycrystalline silicon thin film transistor on the substrate 310 covers an orthographic projection of the active layer 451 on the substrate 410, and an orthographic projection of the gate portion 462 of the photosensitive device on the substrate 410 covers an orthographic projection of the semiconductor portion 461 on the substrate 410; an interlayer insulating layer 430 covering the gate layer and an exposed portion of the gate insulating layer 420 is formed, and photoresist 4104 that is patterned is formed on the interlayer insulating layer 430.

In this embodiment, considering that the liquid crystal display panel includes a backlight source, the display panel further includes a light-blocking layer and a buffer layer that are disposed on a side of the substrate proximate to the semiconductor layer. The semiconductor portion, the first conductor portion and the second conductor portion of the photosensitive device are formed based on the fabricating process of the low-temperature polycrystalline silicon thin film transistor.

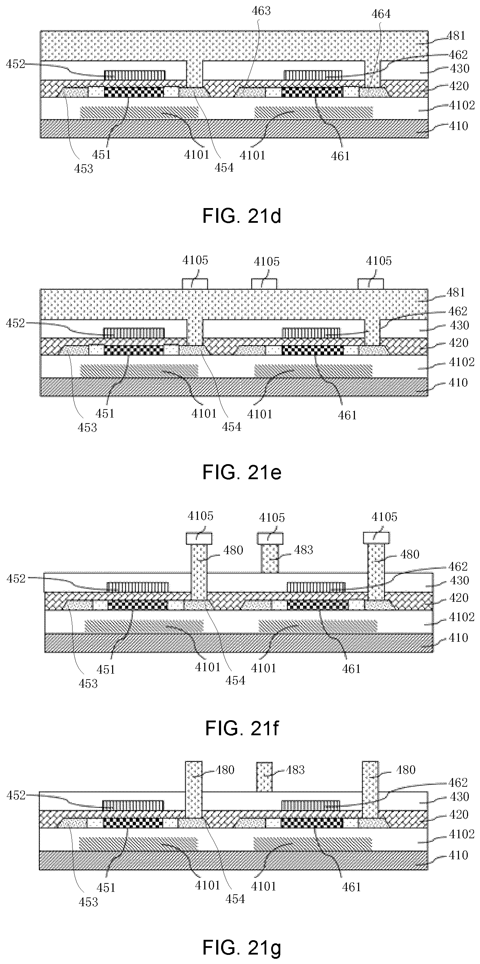

As shown in FIG. 21b, a plurality of first via holes 801 extending to the drain 454 and the second conductor portion 464 are formed in the interlayer insulating layer 430 by using the photoresist 4104; as shown in FIG. 21c, the photoresist 4104 is removed; as shown in FIG. 21d, a first auxiliary conductor material layer 481 is formed on the interlayer insulating layer 430; as shown in FIG. 21e, photoresist 4105 is patterned on the first auxiliary conductor material layer 481; as shown in FIG. 21f, the first auxiliary conductor material layer 481 is patterned to form a plurality of first auxiliary conductor portions 480 and a third auxiliary conductor portion 483, and each first via hole is filled with a respective first auxiliary conductor portion 480; as shown in FIG. 21g, the photoresist 4105 is removed.

In this embodiment, the first auxiliary conductor material layer is formed and patterned to form the first auxiliary conductor portions based on a case that the display substrate includes the gate 452 and the gate portion 462, the process of which is simple.

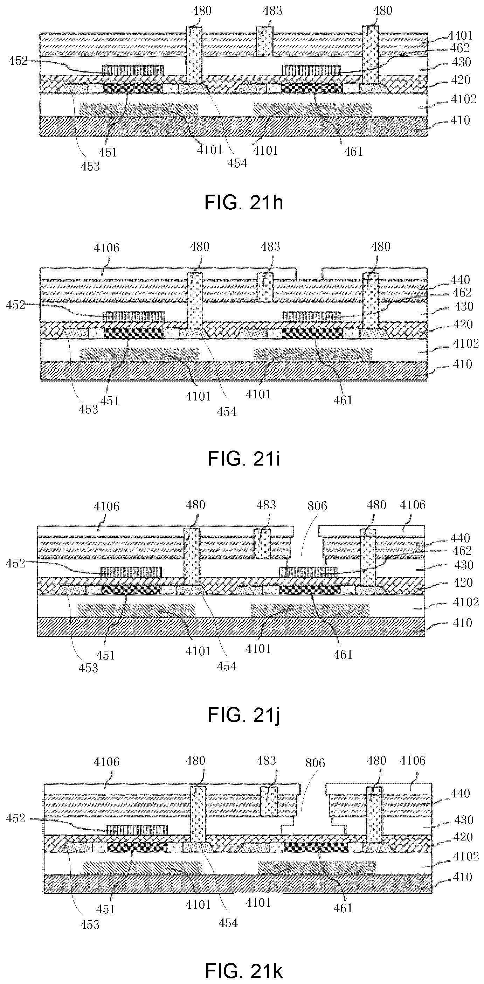

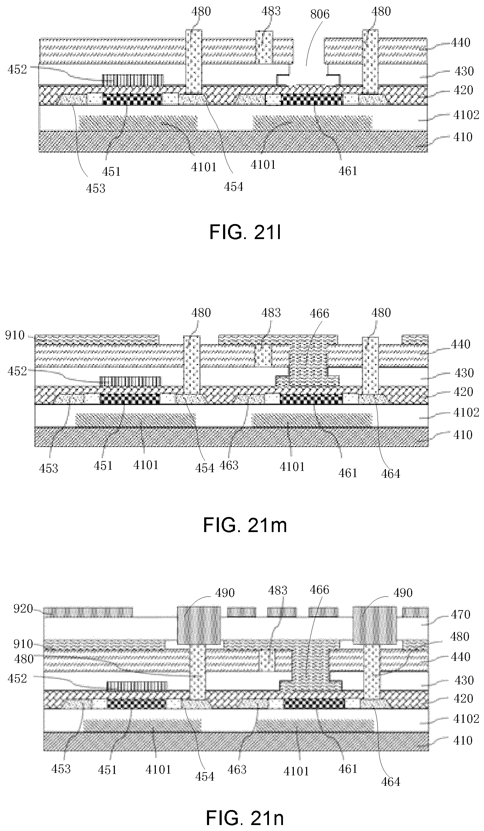

As shown in FIG. 21h, a planarization material layer 4401 is formed on the interlayer insulating layer 430, and the planarization material layer 4401 surrounds the first auxiliary conductor portions 480 and the third auxiliary conductor portion 483; as shown in FIG. 21i, photoresist 4106 is formed on the planarization material layer by using a semi-transparent mask, and the semi-transparent mask has different transmittances corresponding to the gate of the low-temperature polycrystalline silicon thin film transistor and the gate portion of the photosensitive device respectively; for example, the transmittance of the semi-transparent mask at a position corresponding to the gate portion is 0, while the transmittance of the semi-transparent mask at other positions is 100%, which means that an opening is formed in the photoresist 4106 at the position corresponding to the gate portion 462; as shown in FIG. 21j, a planarization layer 440 including a sixth via hole 806 extending to the gate insulating layer 420 is formed by etching; as shown in FIG. 21k, with the shielding of the photoresist 4106, the gate portion 462 is removed by etching through the sixth via hole 806 to expose the gate insulating layer 420, and an orthographic projection of the sixth via hole 806 on the substrate 410 is located within the orthographic projection of the gate portion 462 on the substrate 410; as shown in FIG. 21l, the photoresist 4106 is removed. In this embodiment, the patterned planarization layer is formed and the gate portion of the photosensitive device is removed by using the semi-transparent mask, the process of which is simple.

As shown in FIG. 21m, a common electrode 910 and a gate 466 of the photosensitive device that are both patterned are formed on the planarization layer 440; an orthographic projection of the common electrode 910 on the substrate 410 is non-overlapping with orthographic projections of the first auxiliary conductor portions 480 on the substrate 410; the gate 466 of the photosensitive device is connected to the third auxiliary conductor portion 483, and the sixth via hole 806 is filled with the gate 466 of the photosensitive device. As shown in FIG. 21n, a passivation layer 470 covering the common electrode 910 and the gate 466 of the photosensitive device is formed, and the passivation layer 470 includes a plurality of second via holes each extending to a respective first auxiliary conductor portion 480; pixel electrodes 920 and a plurality of second auxiliary conductor portions 490 that are both patterned are formed on the passivation layer 470; each second via hole is filled with a respective second auxiliary conductor portion 490, and the second auxiliary conductor portions 490 are connected to the drain 454 and the second conductor portion 464 respectively through respective first auxiliary conductor portions 480.

In this way, a photosensor 4000 of the display substrate as shown in FIG. 21n is formed; to be specific, the photosensor includes the patterned semiconductor layer on the substrate; the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from the semiconductor material of the semiconductor layer by conductorization; the photosensor further includes: the gate insulating layer covering the semiconductor layer and the exposed portion of the substrate, the gate of the low-temperature polycrystalline silicon thin film transistor disposed on the gate insulating layer, the interlayer insulating layer covering the gate and the exposed portion of the gate insulating layer; the interlayer insulating layer includes the plurality of first via holes extending to the drain and the second conductor portion; the photosensor further includes the plurality of first auxiliary conductor portions and the third auxiliary conductor portion that are patterned and disposed on the interlayer insulting layer, and each first via hole is filled with a respective first auxiliary conductor portion; the photosensor further includes the planarization layer that is disposed on the interlayer insulating layer and the exposed portion of the gate insulating layer, and surrounds the first auxiliary conductor portions and the third auxiliary conductor portion; the planarization layer includes the sixth via hole extending to the gate insulating layer; the orthographic projection of the sixth via hole on the substrate is located within the orthographic projection of the semiconductor portion on the substrate; the photosensor further includes the patterned gate of the photosensitive device disposed on the planarization layer; the gate of the photosensitive device is connected to the third auxiliary conductor portion, and the sixth via hole is filled with the gate of the photosensitive device.

In this embodiment, based on the display substrate including the gate and the gate portion, as shown in FIG. 24b, the low-temperature polycrystalline silicon thin film transistor including the gate 452 is at the left side of the photosensor 4000, the photosensitive device including the transparent gate is at the right side of the photosensor, and the photosensitive device further includes the semiconductor portion and the conductorized first conductor portion and second conductor portion; the first conductor portion may receive the first signal through a via hole 4630, the second conductor portion may receive the third signal through the first auxiliary conductor portion 480, and the gate of the photosensitive device may receive the fifth signal through a via hole 4630. To be specific, in this embodiment, the first auxiliary conductor material layer is deposited and patterned to form the first auxiliary conductor portions; and then, the patterned planarization layer is formed and the gate portion of the photosensitive device is removed by using the semi-transparent mask, so that the problem that the light cannot be detected due to the shielding of the gate of the top-gate low-temperature polycrystalline silicon thin film transistor may be avoided. Furthermore, the transparent gate of the photosensitive device is formed synchronously with the common electrode, and the transparent gate receives the fifth signal through the third auxiliary conductor portion, so that the photosensitive current output by the photosensitive device may be controlled. As a result, the photosensitive device based on the low-temperature polycrystalline silicon thin film transistor is realized with characteristics of simple process and manufacture.

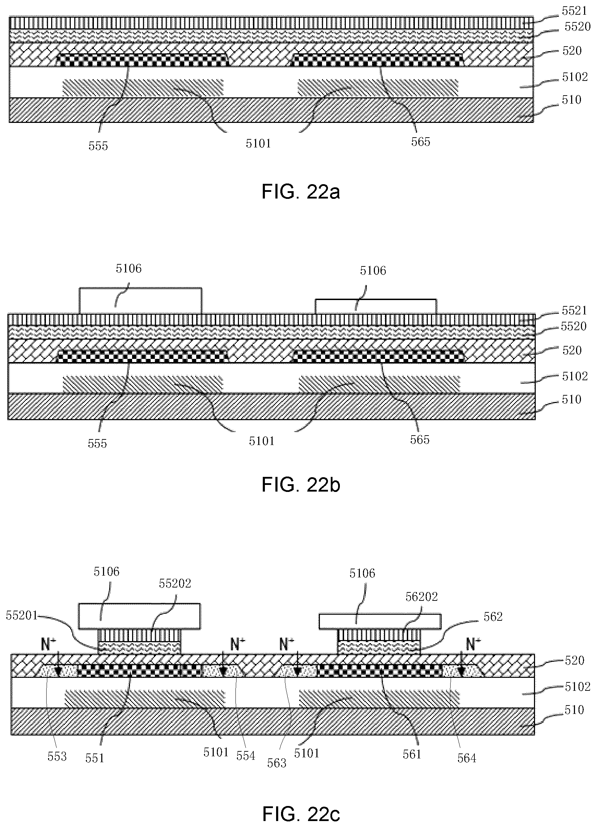

In another specific embodiment, a specific manufacturing process of the display substrate is described below by still taking an example in which the display substrate is applied to the liquid crystal display panel, referring to FIGS. 22a to 22h, the manufacturing process includes the following steps.

As shown in FIG. 22a, a semiconductor layer that is patterned is formed on a substrate 510, and the semiconductor layer includes a semiconductor structure 555 of the low-temperature polycrystalline silicon thin film transistor and a semiconductor structure 565 of the photosensitive device; a gate insulating layer 520 covering the semiconductor layer and an exposed portion of substrate 510 is formed; a first gate material layer 5520 and a second gate material layer 5521 that are stacked are formed on the gate insulating layer 520; the first gate material layer is made of a transparent material, such as indium tin oxide (ITO).

In this embodiment, considering that the liquid crystal display panel includes a backlight source, the display substrate further includes a light-blocking layer and a buffer layer that are disposed on a side of the substrate proximate to the semiconductor layer.

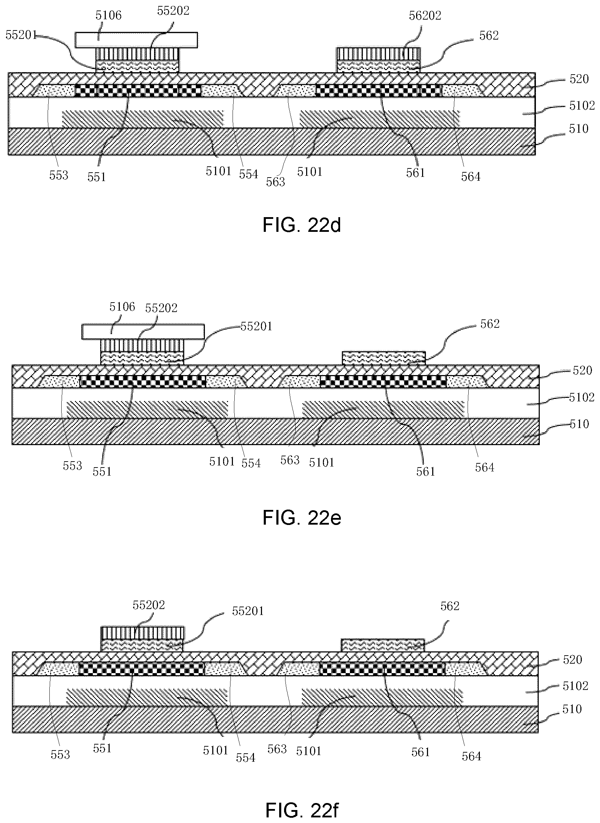

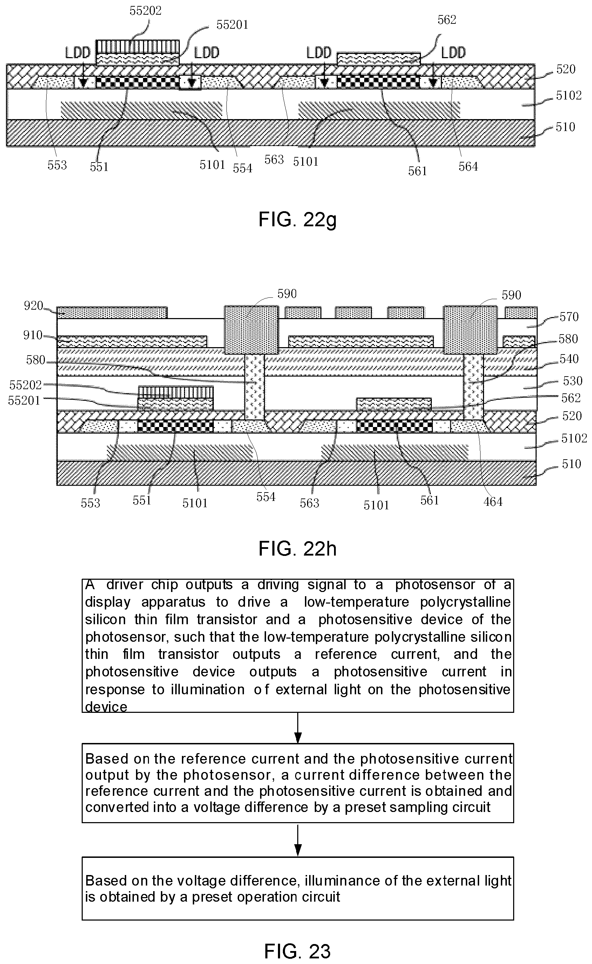

As shown in FIG. 22b, the first gate material layer 5520 and the second gate material layer 5521 that are stacked are patterned to form a gate layer by using a semi-transparent mask; the semi-transparent mask has different transmittances corresponding to a gate of the low-temperature polycrystalline silicon thin film transistor and a gate portion of the photosensitive device respectively, and photoresist 5106 with different thicknesses is formed on the second gate material layer 5521; as shown in FIG. 22c, the gate of the low-temperature polycrystalline silicon thin film transistor and the gate portion of the photosensitive device are formed by etching; the gate of the low-temperature polycrystalline silicon thin film transistor includes a first gate 55201 formed from the first gate material layer 5520 and a second gate 55202 formed from the second gate material layer 5521, and the gate portion of the photosensitive device includes a gate 562 formed from the first gate material layer 5520 and a gate sub-portion 56202 formed from the second gate material layer 5521; a first conductorization process is performed on the semiconductor structure 555 and the semiconductor structure 565 by using the photoresist 5106 as a mask; that is, an N-type doping is performed on portions of the semiconductor structures that are not covered by the photoresist 5106 with ions; as shown in FIG. 22d, a portion of the photoresist 5106 is removed by etching; to be specific, a portion of the photoresist on the gate portion is removed to expose the gate sub-portion 56202, and another portion of the photoresist 5106 on the gate of the low-temperature polycrystalline silicon thin film transistor is thinned; as shown in FIG. 22e, the gate sub-portion 56202 is removed by etching to expose the transparent gate 562 of the photosensitive device; as shown in FIG. 22f, the portion of the photoresist on the gate of the low-temperature polycrystalline silicon thin film transistor is removed to expose the second gate 55202; as shown in FIG. 22g, a second conductorization process is performed, that is, a second doping process is performed on portions, that are not covered, of the gate of the low-temperature polycrystalline silicon thin film transistor and the gate of the photosensitive device to form LDD structures, so as to form an active layer 551, a source 553 and a drain 554 of the low-temperature polycrystalline silicon thin film transistor, as well as a semiconductor portion 561, a first conductor portion 563 and a second conductor portion 564 of the photosensitive device; an orthographic projection of the gate of the low-temperature polycrystalline silicon thin film transistor on the substrate and an orthographic projection of the active layer on the substrate overlap, and an orthographic projection of the gate of the photosensitive device on the substrate and an orthographic projection of the semiconductor portion on the substrate overlap.

In this embodiment, the gate of the low-temperature polycrystalline silicon thin film transistor including the first gate and the second gate and the gate of the photosensitive device are formed using the semi-transparent mask; in other words, with the semi-transparent mask having difference transmittances, the gate sub-portion of the photosensitive device may be removed by etching, so as to realize that the transparent gate of the photosensitive device is formed, and the low-temperature polycrystalline silicon thin film transistor includes the transparent first gate and the opaque second gate that are stacked, which may ensure that the low-temperature polycrystalline silicon thin film transistor is in normal operation and outputs a reference current. Furthermore, the semiconductor structures are conductorized while the gates are formed, so as to form the active layer, the source and the drain of the low-temperature polycrystalline silicon thin film transistor, as well as the semiconductor portion, the first conductor portion and the second conductor portion of the photosensitive device.

As shown in FIG. 22h, an interlayer insulating layer 530 covering the gate layer and an exposed portion of the gate insulating layer 520 is formed, and the interlayer insulating layer includes a plurality of first via holes extending to the drain 554 and the second conductor portion 564; a plurality of first auxiliary conductor portions 580 that are patterned are formed on the interlayer insulating layer 530, and each first via hole is filled with a respective first auxiliary conductor portion 580; a planarization layer 540 surrounding the first auxiliary conductor portions 580 is formed on the interlayer insulating layer 530; a common electrode 910 that is patterned is formed on the planarization layer 540, and an orthographic projection of the common electrode 910 on the substrate 510 is non-overlapping with orthographic projections of the first auxiliary conductor portions 580 on the substrate 510; a passivation layer 570 covering the common electrode 910 is formed, and the passivation layer includes a plurality of second via holes each extending to a respective first auxiliary conductor portion 580; pixel electrodes 920 and a plurality of second auxiliary conductor portions 590 that are both patterned are formed on the passivation layer 570; each second via hole is filled with a respective second auxiliary conductor portion 590, and the second auxiliary conductor portions 590 are connected to the drain 554 and the second conductor portion 564 respectively through respective first auxiliary conductor portions 580.

In this way, a photosensor 5000 of the display substrate as shown in FIG. 22h is formed; to be specific, the photosensor includes the semiconductor layer that is patterned and disposed on the substrate. The semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from the semiconductor material of the semiconductor layer by conductorization. The photosensor further includes: the gate insulating layer covering the semiconductor layer and the exposed portion of the substrate, and the gate layer that is patterned and disposed on the gate insulating layer. The gate layer includes the gate of the low-temperature polycrystalline silicon thin film transistor and the gate of the photosensitive device; the gate of the low-temperature polycrystalline silicon thin film transistor includes the first gate and the second gate that are stacked, the gate of the photosensitive device is disposed in the same layer as the first gate, and the first gate is made of a transparent material. The photosensor further includes the interlayer insulating layer covering the gate layer and the exposed portion of the gate insulating layer, and the interlayer insulating layer includes the plurality of first via holes extending to the drain and the second conductor portion. The photosensor further includes the plurality of first auxiliary conductor portions that are patterned and disposed on the interlayer insulting layer, and each first via hole is filled with a respective first auxiliary conductor portion. The photosensor further includes the planarization layer disposed on the interlayer insulating layer, and the planarization layer surrounds the first auxiliary conductor portions.

In this embodiment, as shown in FIG. 24c, the low-temperature polycrystalline silicon thin film transistor including the gate 552 is at the left side of the photosensor 5000, the photosensitive device including the transparent gate is at the right side of the photosensor, and the photosensitive device further includes the semiconductor portion 551 and the conductorized first conductor portion and second conductor portion; the first conductor portion may receive a first signal through a via hole 5630, the second conductor portion may receive a third signal through the first auxiliary conductor portion 580, and the gate 562 of the photosensitive device may receive a fifth signal through a via hole 3630. To be specific, the opaque gate including the stacked first gate and second gate of the low-temperature polycrystalline silicon thin film transistor and the transparent gate of the photosensitive device are formed using the semi-transparent mask, which may avoid the problem that the light cannot be detected due to the shielding of the gate the top-gate low-temperature polycrystalline silicon thin film transistor. Furthermore, the semiconductor structures are conductorized while the gates are formed, so as to form the active layer, the source and the drain of the low-temperature polycrystalline silicon thin film transistor, as well as the semiconductor portion, the first conductor portion and the second conductor portion of the photosensitive device. Thus, the photosensitive current output by the photosensitive device may be control based on the fifth signal applied to the gate of the photosensitive device, so that the photosensitive device based on the low-temperature polycrystalline silicon thin film transistor is realized.

FIG. 25b is a comparative diagram of photosensitive currents output by the photosensors 3000/4000/5000 in the above three embodiments under condition without illumination and under condition of illumination; in this figure, the axis x represents the voltage Vg, and the axis y represents the current Id. As can be seen from the figure, in a case where there is no illumination and the voltage applied to the gate of the photosensitive device is V1, the output photosensitive current is I01; in a case where there is no illumination and the voltage applied to the gate of the photosensitive device is V2, the output photosensitive current is I02; under condition of illumination, the photosensitive current output by the photosensor 3000/4000/5000 is increased based on a base current Id; that is, the photosensitive current output by the photosensor is increased in response to that external light is detected. To be specific, in the case where the voltage applied to the gate of the photosensitive device is V1, the output photosensitive current is I01'; in the case where the voltage applied to the gate of the photosensitive device is V2, the output photosensitive current is I02'. As can be seen from the figure, as the voltage at the gate of the photosensitive device changes (e.g., changing from V1 to V2), the photosensitive current output by the photosensor 3000/4000/5000 changes accordingly. That is, the magnitude of the photosensitive current may be adjusted by adjusting the voltage at the gate of the photosensitive device, so that the value of the photosensitive current is in a range that can be easily measured by the sampling circuit and operation circuit at the back-end and the photosensitive current is not too sensitive. In this way, the measurement precision of the photosensitive device may be effectively improved.

Based on the above display substrate, the present disclosure provides a liquid crystal display panel formed based on the above embodiments.

Similarly, based on the above display substrate, the present disclosure provides an electroluminescent diode display panel including the above display substrate.

In these embodiments, based on a photosensor including a photosensitive device formed without a gate or a photosensor including a photosensitive device formed with a transparent gate, the photosensor is provided in the electroluminescent diode display panel based on the formed low-temperature polycrystalline silicon thin film transistor, so that the electroluminescent diode display panel has a function of automatically detecting ambient light illuminance and is capable of adjusting the brightness of the display panel according to the ambient light illuminance. Those skilled in the art should understand that, based on the above display substrate, the input signals are configured, to be input to the photosensor, for example, in combination with the manufacturing process of the electroluminescent diode display panel, which will not be described in detail here.

Based on the above liquid crystal display panel or electroluminescent diode display panel, the present disclosure provides a display apparatus, which includes the above liquid crystal display panel or electroluminescent diode display panel, and a driver chip; the driver chip is used to output signals to the photosensor of the display substrate of the liquid crystal display panel or electroluminescent diode display panel, so as to drive the low-temperature polycrystalline silicon thin film transistor and photosensitive device of the photosensor.

In these embodiments, the display apparatus includes the photosensor disposed in the driving circuit layer that is located in the non-display region, and including the low-temperature polycrystalline silicon thin film transistor and the photosensitive device, so that a function of an automatic detection of ambient light is achieved. To be specific, the low-temperature polycrystalline silicon thin film transistor of the photosensor is used to output a reference current; the photosensitive device is a device, for outputting a photosensitive current, capable of sensing light and formed by at least part of elements of a low-temperature polycrystalline silicon thin film transistor. That is, the photosensor is capable of automatically detecting ambient light and outputting a photosensitive current and a reference current. Especially, in the embodiments of the present disclosure, a semi-transparent mask is used in various processes to form photosensitive devices of different structures, so as to realize fabricating photosensitive devices based on low-temperature polycrystalline silicon thin film transistors with the process of the existing low-temperature polycrystalline silicon thin film transistor. In this way, the problems existing in the related art may be alleviated, the manufacturing efficiency of the display substrate may be effectively improved, and the manufacturing process may be simplified to reduce cost and increase market competitiveness.

In an optional embodiment, as shown in FIG. 15, the display apparatus further includes a sampling circuit and an operation circuit; the sampling circuit is used to obtain a current difference between the reference current and the photosensitive current output by the photosensor and convert the current difference into a voltage difference; and the operation circuit is used to obtain external light illuminance based on the voltage difference.

In these embodiments, the reference current and the output current differ by at least one order of magnitude, and the voltage difference corresponding to the current difference between the reference current and the output current is obtained by the sampling circuit, and then the illuminance of external light is obtained based on the voltage difference by the operation circuit, such as an analog-to-digital converter and a digital operation circuit, thereby realizing the detection of the illuminance of external ambient light. In a case where it is detected that the illuminance of the external ambient light is too high or too low, the brightness of the display apparatus may be adjusted according to the ambient illuminance. For example, for a display apparatus based on a liquid crystal display panel, the function of adjusting the brightness of the display screen may be achieved by adjusting a current of a backlight source.

It is worth noting that the structure of the operation circuit is not specifically limited in the present disclosure, and the detection may be realized by means of charge integration or voltage detection, and those skilled in the art may select an appropriate operation circuit based on actual application requirements, which will not be elaborated here.

Corresponding to the display apparatus provided in the above embodiments, an embodiment of the present disclosure provides an ambient light detection method using the above display apparatus, as shown in FIG. 23, the detection method includes the following steps.

The driver chip outputs a driving signal, for driving the low-temperature polycrystalline silicon thin film transistor and the photosensitive device of the photosensor, to the photosensor of the display apparatus, such that the low-temperature polycrystalline silicon thin film transistor outputs a reference current, and the photosensitive device outputs a photosensitive current in response to illumination of external light.

Based on the reference current and the photosensitive current output by the photosensor, a current difference between the reference current and the photosensitive current is obtained and converted into a voltage difference by a preset sampling circuit.

Based on the voltage difference, illuminance of the external light is obtained by a preset operation circuit.

In the ambient light detection method of these embodiments, based on the display apparatus in the above embodiments, the reference current and the output current, differ by at least one order of magnitude, are output by the photosensor of the display apparatus, the voltage difference corresponding to the current difference between the reference current and the output current is obtained by the sampling circuit, and the illuminance of the external light is obtained based on the voltage difference by the operation circuit, such as an analog-to-digital converter and a digital operation circuit, thereby realizing the detection of the illuminance of the external ambient light. In a case where it is detected that the illuminance of the external ambient light is too high or too low, the brightness of the display apparatus may be adjusted according to the ambient illuminance. For example, for a display apparatus based on a liquid crystal display panel, the function of adjusting the brightness of the display screen may be achieved by adjusting a current of a backlight source. Since the ambient light detection method provided in these embodiments of the present disclosure corresponds to the display apparatus provided in the above several embodiments, the aforegoing embodiments are also applicable to the ambient light detection method provided in these embodiments, which will not be elaborated in this embodiment.

Based on the display substrate of the above embodiments, the present disclosure provides a manufacturing method of the display substrate, and the manufacturing method includes the following steps.

A driving circuit layer is formed on a substrate, and the driving circuit layer includes a photosensor formed in a non-display region; the photosensor includes a low-temperature polycrystalline silicon thin film transistor and a photosensitive device; the photosensitive device includes a semiconductor portion disposed in a same layer as an active layer of the low-temperature polycrystalline silicon thin film transistor, a first conductor portion disposed in a same layer as a source of the low-temperature polycrystalline silicon thin film transistor, and a second conductor portion disposed in a same layer as a drain of the low-temperature polycrystalline silicon thin film transistor; the photosensitive device outputs a photosensitive current in response to an input signal and illumination of the external light on the semiconductor portion, and the low-temperature polycrystalline silicon thin film transistor outputs a reference current in response to an input signal.

In these embodiments, based on the fabricating process of the existing low-temperature polycrystalline silicon thin film transistor, the photosensitive device based on the low-temperature polycrystalline silicon thin film transistor may be formed to form the photosensor. That is, the photosensor is formed based on the mask used in the fabricating process of the existing low-temperature polycrystalline silicon thin film transistor. In this way, the problems existing in the related art may be alleviated, which may effectively improve the manufacturing efficiency of the display substrate, so that the manufacturing process may be simplified to reduce cost and increase market competitiveness.

In an optional embodiment, after the driving circuit layer is formed on the substrate, the manufacturing method further includes the following step.

A black matrix is formed on the driving circuit layer in the non-display region; an orthographic projection of the black matrix on the substrate covers an orthographic projection of the low-temperature polycrystalline silicon thin film transistor on the substrate, and the orthographic projection of the black matrix on the substrate is non-overlapping with an orthographic projection of the photosensitive device on the substrate.

In this embodiment, considering that the reliability of the reference current may be affected caused by a fact that the low-temperature polycrystalline silicon thin film transistor is easily affected by external light and other light in the display substrate, the black matrix on the driving circuit layer in the structure of the array substrate is used to cover the low-temperature polycrystalline silicon thin film transistor, thereby ensuring that the low-temperature polycrystalline silicon thin film transistor outputs a reference current suitable for reference according to the input signal, which may effectively improve the accuracy and sensitivity of the photosensor.

In an optional embodiment, forming the driving circuit layer on the substrate includes the following steps.

A semiconductor layer that is patterned is formed on the substrate; the semiconductor layer includes a semiconductor structure of the low-temperature polycrystalline silicon thin film transistor and a semiconductor structure of the photosensitive device.

A gate insulating layer covering the semiconductor layer and an exposed portion of the substrate is formed.

A gate layer patterned on the gate insulating layer is formed; the gate layer includes a gate of the low-temperature polycrystalline silicon thin film transistor and a gate portion of the photosensitive device.

A conductorization process is performed on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap.

An interlayer insulating layer that is patterned is formed by using a semi-transparent mask; the semi-transparent mask has different transmittances corresponding to the gate of the low-temperature polycrystalline silicon thin film transistor and the gate portion of the photosensitive device respectively; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate.

The gate portion of the photosensitive device is removed by etching to expose the gate insulating layer.

A plurality of first via holes extending to the drain and the second conductor portion in the interlayer insulating layer are formed.

A plurality of first auxiliary conductor portions that are patterned are formed on the interlayer insulating layer; each first via hole is filled with a respective first auxiliary conductor portion.

A planarization layer is formed on the interlayer insulating layer and an exposed portion of the gate insulating layer; the planarization layer surrounds the first auxiliary conductor portions.

In this embodiment, by using the fabricating process of the existing low-temperature polycrystalline silicon thin film transistor, based on the formed semiconductor portion, first conductor portion and second conductor portion of the photosensitive device, the interlayer insulating layer is formed by using the semi-transparent mask to remove the gate portion of the photosensitive device, which may avoid the problem that the light cannot be detected due to the shielding of the gate of the top-gate low-temperature polycrystalline silicon thin film transistor, thereby realizing a photosensitive device based on a low-temperature polycrystalline silicon thin film transistor.

In an optional embodiment, forming the driving circuit layer on the substrate includes the following steps.

A semiconductor layer that is patterned is formed on the substrate; the semiconductor layer includes a semiconductor structure of the low-temperature polycrystalline silicon thin film transistor and a semiconductor structure of the photosensitive device.

A gate insulating layer covering the semiconductor layer and an exposed portion of the substrate is formed.

A gate layer that is patterned is formed on the gate insulating layer by using a semi-transparent mask; the gate layer includes a gate of the low-temperature polycrystalline silicon thin film transistor and a gate portion of the photosensitive device; the semi-transparent mask has different transmittances corresponding to the gate and the gate portion respectively.

A first conductorization is performed on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap.

The gate portion of the photosensitive device is removed by etching to expose the gate insulating layer.

A second conductorization is performed on the semiconductor layer.

An interlayer insulating layer is formed on the gate and an exposed portion of the gate insulating layer; the interlayer insulating layer includes a plurality of first via holes extending to the drain and the second conductor portion.

A plurality of first auxiliary conductor portions that are patterned are formed on the interlayer insulating layer; each first via hole is filled with a respective first auxiliary conductor portion.

A planarization layer is formed on the interlayer insulating layer; the planarization layer surrounds the first auxiliary conductor portions.

In this embodiment, by using the fabricating process of the existing low-temperature polycrystalline silicon thin film transistor, the gate is formed by using the semi-transparent mask, and after the semiconductor structures are subjected to a first conductorization process, the gate portion of the photosensitive device is removed and the semiconductor portion of the photosensitive device is conductorized. **In** this way, the problem that the light cannot be detected due to the shielding of the gate of the top-gate low-temperature polycrystalline silicon thin film transistor may be avoided, thereby realizing a photosensitive device based on a low-temperature polycrystalline silicon thin film transistor; furthermore, the sensitivity of the photosensitive device to external light may be improved, thereby improving the accuracy and sensitivity of the photosensor.

In an optional embodiment, forming the driving circuit layer on the substrate includes the following steps.

A semiconductor layer that is patterned is formed on the substrate; the semiconductor layer includes a semiconductor structure of the low-temperature polycrystalline silicon thin film transistor and a semiconductor structure of the photosensitive device.

A gate insulating layer covering the semiconductor layer and an exposed portion of the substrate is formed.

A gate layer that is patterned is formed on the gate insulating layer; the gate layer includes a gate of the low-temperature polycrystalline silicon thin film transistor and a gate portion of the photosensitive device.

A conductorization process is performed on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap.

A patterned interlayer insulating layer is formed by using a semi-transparent mask; the semi-transparent mask has different transmittances corresponding to the gate of the low-temperature polycrystalline silicon thin film transistor and the gate portion of the photosensitive device respectively; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate.

The gate portion of the photosensitive device is removed by etching to expose the gate insulating layer.

A plurality of first via holes extending to the drain and the second conductor portion and a third via hole extending to the gate insulating layer are formed in the interlayer insulating layer.

A plurality of first auxiliary conductor portions and a third auxiliary conductor portion that are patterned are formed on the interlayer insulating layer; each first via hole is filled with a respective first auxiliary conductor portion.

A planarization layer is formed on the interlayer insulating layer, the third auxiliary conductor portion and a portion of gate insulating layer exposed by the third via hole; the planarization layer surrounds the first auxiliary conductor portion.

A fourth via hole extending to the third auxiliary conductor portion and a fifth via hole extending to the gate insulating layer are formed in the planarization layer; an orthographic projection of the fifth via hole on the substrate is located within the orthographic projection of the semiconductor portion of the photosensitive device on the substrate, and the orthographic projection of the fifth via hole on the substrate is located within an orthographic projection of the third via hole on the substrate.

A gate of the photosensitive device that is patterned is formed on the planarization layer; the fourth via hole and the fifth via hole are filled with the gate of the photosensitive device, and the gate of the photosensitive device is connected to the third auxiliary conductor portion through the fourth via hole.

In this embodiment, by using the fabricating process of the existing low-temperature polycrystalline silicon thin film transistor, based on the formed semiconductor portion, first conductor portion and second conductor portion of the photosensitive device, the interlayer insulating layer is formed by using the semi-transparent mask to remove the gate portion of the photosensitive device, which may avoid the problem that the light cannot be detected due to the shielding of the gate of the top-gate low-temperature polycrystalline silicon thin film transistor; furthermore, the transparent gate of the photosensitive device is formed and receives the fifth signal through the third auxiliary conductor portion, so that the photosensitive current output by the photosensitive device may be controlled. As a result, the photosensitive device based on the low-temperature polycrystalline silicon thin film transistor is realized.

In an optional embodiment, forming the driving circuit layer on the substrate includes the following steps.

A semiconductor layer that is patterned is formed on the substrate; the semiconductor layer includes a semiconductor structure of the low-temperature polycrystalline silicon thin film transistor and a semiconductor structure of the photosensitive device.

A gate insulating layer covering the semiconductor layer and an exposed portion of the substrate is formed.

A gate layer that is patterned is formed on the gate insulating layer; the gate layer includes a gate of the low-temperature polycrystalline silicon thin film transistor and a gate portion of the photosensitive device.

A conductorization process is performed on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap.

An interlayer insulating layer covering the gate layer and an exposed portion of the gate insulating layer is formed; the interlayer insulating layer includes a plurality of first via holes extending to the drain and the second conductor portion.

A plurality of first auxiliary conductor portions and a third auxiliary conductor portion that are patterned are formed on the interlayer insulating layer; each first via hole is filled with a respective first auxiliary conductor portion.

A planarization material layer is formed on the interlayer insulating layer; the planarization material layer surrounds the first auxiliary conductor portions and the third auxiliary conductor portion.

A sixth via hole extending to the gate insulating layer is formed in the planarization material layer by using a semi-transparent mask; the gate portion is removed by etching through the sixth via hole to expose the gate insulating layer; an orthographic projection of the sixth via hole on the substrate is located within the orthographic projection of the gate portion on the substrate; the semi-transparent mask has different transmittances corresponding to the gate of the low-temperature polycrystalline silicon thin film transistor and the gate portion of the photosensitive device respectively.

A gate of the photosensitive device that is patterned is formed on the planarization layer; the gate of the photosensitive device is connected to the third auxiliary conductor portion, and the sixth via hole is filled with the gate of the photosensitive device.

In this embodiment, based on the gate and the gate portion being formed in the display substrate, a first auxiliary conductor material layer is formed by deposition and is patterned to form the first auxiliary conductor portions; the planarization layer that is patterned is formed by using the semi-transparent mask to remove the gate portion of the photosensitive device, which may avoid the problem that the light cannot be detected due to the shielding of the gate of the top-gate low-temperature polycrystalline silicon thin film transistor; moreover, the transparent gate of the photosensitive device is formed synchronously with the common electrode, and the transparent gate receives the fifth signal through the third auxiliary conductor portion, so that the photosensitive current output by the photosensitive device may be controlled. As a result, the photosensitive device based on the low-temperature polycrystalline silicon thin film transistor is realized with characteristics of simple process and manufacture.

In an optional embodiment, forming the driving circuit layer on the substrate includes the following steps.

A semiconductor layer that is patterned is formed on the substrate; the semiconductor layer includes a semiconductor structure of the low-temperature polycrystalline silicon thin film transistor and a semiconductor structure of the photosensitive device.

A gate insulating layer covering the semiconductor layer and an exposed portion of the substrate is formed.

A first gate material layer and a second gate material layer that are stacked are formed on the gate insulating layer; the first gate material layer is made of a transparent material.

The first gate material layer and the second gate material layer that are stacked are patterned by using a semi-transparent mask to form a gate layer, and a conductorization process is performed on the semiconductor layer; the gate layer includes a gate of the low-temperature polycrystalline silicon thin film transistor and a gate of the photosensitive device; the gate of the low-temperature polycrystalline silicon thin film transistor includes a first gate formed by patterning the first gate material layer, and a second gate formed by patterning the second gate material layer, and the first gate and the second gate are stacked; the gate of the photosensitive device is disposed in the same layer as the first gate; the semi-transparent mask has different transmittances corresponding to the gate of the low-temperature polycrystalline silicon thin film transistor and the gate of the photosensitive device respectively; the semiconductor structure of the low-temperature polycrystalline silicon thin film transistor being formed into an active layer, and a source and a drain respectively disposed on two sides of the active layer; the semiconductor structure of the photosensitive device being formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate of the photosensitive device on the substrate and an orthographic projection of the semiconductor portion on the substrate overlap.

An interlayer insulating layer covering the gate layer and an exposed portion of the gate insulating layer is formed; the interlayer insulating layer includes a plurality of first via holes extending to the drain and the second conductor portion.

A plurality of first auxiliary conductor portions that are patterned are formed on the interlayer insulating layer; each first via hole is filled with a respective first auxiliary conductor portion.

A planarization layer is formed on the interlayer insulating layer; the planarization layer surrounds the first auxiliary conductor portion.

In this embodiment, the opaque gate including the stacked first gate and second gate of the low-temperature polycrystalline silicon thin film transistor and the transparent gate of the photosensitive device are formed by using the semi-transparent mask, which may avoid the problem that the light cannot be detected due to the shielding of the gate of the top-gate low-temperature polycrystalline silicon thin film transistor; furthermore, the semiconductor structures are conductorized based on the formed gates to form the active layer, the source and the drain of the low-temperature polycrystalline silicon thin film transistor, as well as the semiconductor portion, the first conductor portion and the second conductor portion of the photosensitive device. In this way, the photosensitive current output by the photosensitive device may be control based on the fifth signal applied to the gate of the photosensitive device, so that the photosensitive device based on the low-temperature polycrystalline silicon thin film transistor is realized.

The above are merely specific embodiments of the present disclosure, but the protection scope of the present disclosure is not limited to thereto, and variations or substitutions that any person skilled in the art may conceive of within the technical scope of the present disclosure should all fall within the protection scope of the present disclosure. Therefore, the protection scope of the present disclosure should be subject to the protection scope of the claims.

## Claims

1. A display substrate having a display region and a non-display region, comprising:
a substrate; and
a driving circuit layer disposed on the substrate, wherein the driving circuit layer includes a photosensor in the non-display region, and the photosensor includes a photosensitive device; the photosensitive device includes a semiconductor portion, a first conductor portion and a second conductor portion; the photosensitive device further includes a gate, and at least a portion of the gate is a light-transmitting portion; a material of the light-transmitting portion is a light-transmitting material, and the light-transmitting portion penetrates the gate; and an orthographic projection of the light-transmitting portion on the substrate overlaps with an orthographic projection of the semiconductor portion on the substrate.

2. The display substrate according to claim 1, wherein a portion of the semiconductor portion whose orthographic projection on the substrate is non-overlapping with the gate is a first portion; and
the semiconductor portion further includes a lightly doped drain, and the lightly doped drain is included in the first portion.

3. The display substrate according to claim 2, wherein an orthographic projection of the lightly doped drain on the substrate overlaps with an orthographic projection of the light-transmitting portion on the substrate.

4. The display substrate according to claim 3, wherein the orthographic projection of the lightly doped drain on the substrate covers an orthographic projection of the gate on the substrate.

5. The display substrate according to claim 3, wherein in an extension direction of the substrate, a dimension of the lightly doped drain is less than or equal to 0.5 um.

6. The display substrate according to claim 2, wherein the photosensor includes two photosensitive devices; one of the two photosensitive devices outputs a photosensitive current in response to an input signal and illumination of external light on a semiconductor portion thereof, and another of the two photosensitive devices outputs a reference current in response to an input signal.

7. The display substrate according to claim 6, wherein in an extension direction of the substrate, dimensions of lightly doped drains of the two photosensitive devices are same or different.

8. The display substrate according to claim 7, wherein the display substrate further comprises a black matrix disposed on the driving circuit layer; an orthographic projection of the black matrix on the substrate covers an orthographic projection of the another one of the two photosensitive devices on the substrate, and the orthographic projection of the black matrix on the substrate is non-overlapping with an orthographic projection of the one of the two photosensitive devices on the substrate.

9. The display substrate according to claim 1, wherein the photosensor further includes a low-temperature polycrystalline silicon thin film transistor; the low-temperature polycrystalline silicon thin film transistor includes an active layer disposed in a same layer as the semiconductor portion of the photosensitive device, a source disposed in a same layer as the first conductor portion of the photosensitive device, and a drain disposed in a same layer as the second conductor portion of the photosensitive device; the photosensitive device outputs a photosensitive current in response to an input signal and illumination of external light on the semiconductor portion, and the low-temperature polycrystalline silicon thin film transistor outputs a reference current in response to an input signal.

10. The display substrate according to claim 9, wherein the low-temperature polycrystalline silicon thin film transistor is of a top-gate structure; and
the source of the low-temperature polycrystalline silicon thin film transistor and the first conductor portion of the photosensitive device receive a first signal, the drain of the low-temperature polycrystalline silicon thin film transistor receives a second signal, the second conductor portion of the photosensitive device receives a third signal, and a gate of the low-temperature polycrystalline silicon thin film transistor receives a fourth signal.

11. The display substrate according to claim 9, wherein the display substrate further comprises a black matrix disposed on the driving circuit layer; and
an orthographic projection of the black matrix on the substrate covers an orthographic projection of the low-temperature polycrystalline silicon thin film transistor on the substrate, and the orthographic projection of the black matrix on the substrate is non-overlapping with an orthographic projection of the photosensitive device on the substrate.

12. The display substrate according to any one of claims 9 to 11, wherein the display substrate comprises:
a semiconductor layer that is patterned and disposed on the substrate, wherein the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from a semiconductor material of the semiconductor layer by conductorization;
a gate insulating layer covering the semiconductor layer and an exposed portion of the substrate;
a gate of the low-temperature polycrystalline silicon thin film transistor disposed on the gate insulating layer;
an interlayer insulating layer covering the gate and an exposed portion of the gate insulating layer, wherein the interlayer insulating layer includes a plurality of first via holes extending to the drain and the second conductor portion;
a plurality of first auxiliary conductor portions that are patterned and disposed on the interlayer insulating layer for receiving input signals, wherein each first via hole is filled with a respective first auxiliary conductor portion; and
a planarization layer disposed on the interlayer insulating layer and surrounding the first auxiliary conductor portions.

13. The display substrate according to any one of claims 9 to 11, wherein the photosensitive device is a thin film transistor, the semiconductor portion of the photosensitive device is an active layer, the first conductor portion of the photosensitive device is a source, and the second conductor portion of the photosensitive device is a drain; and
the gate of the photosensitive device receives a fifth signal, and the photosensitive device outputs the photosensitive current in response to a first signal, a third signal, the fifth signal and the illumination of external light on the semiconductor portion.

14. The display substrate according to claim 13, wherein the display substrate comprises:
a semiconductor layer that is patterned and disposed on the substrate, wherein the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from a semiconductor material of the semiconductor layer by conductorization;
a gate insulating layer covering the semiconductor layer and an exposed portion of the substrate;
a gate of the low-temperature polycrystalline silicon thin film transistor disposed on the gate insulating layer;
an interlayer insulating layer covering the gate and an exposed portion of the gate insulating layer, wherein the interlayer insulating layer includes a plurality of first via holes extending to the drain and the second conductor portion and a third via hole extending to the gate insulating layer;
a plurality of first auxiliary conductor portions and a plurality of third auxiliary conductor portions that are both patterned and disposed on the interlayer insulating layer for receiving input signals, wherein each first via hole is filled with a respective first auxiliary conductor portion;
a planarization layer disposed on the interlayer insulating layer, the third auxiliary conductor portions and an exposed portion of the gate insulating layer, wherein the planarization layer surrounds the first auxiliary conductor portions, and the planarization layer includes a fourth via hole extending to a third auxiliary conductor portion and a fifth via hole extending to the gate insulating layer; an orthographic projection of the fifth via hole on the substrate is located within an orthographic projection of the semiconductor portion of the photosensitive device on the substrate, and the orthographic projection of the fifth via hole on the substrate is located within an orthographic projection of the third via hole on the substrate; and
the gate of the photosensitive device disposed on the planarization layer, wherein the fourth via hole and the fifth via hole are filled with the gate of the photosensitive device, and the gate of the photosensitive device is connected to the third auxiliary conductor portion through the fourth via hole.

15. The display substrate according to claim 13, wherein the display substrate comprises:
a semiconductor layer that is patterned and disposed on the substrate, wherein the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from a semiconductor material of the semiconductor layer by conductorization;
a gate insulating layer covering the semiconductor layer and an exposed portion of the substrate;
a gate of the low-temperature polycrystalline silicon thin film transistor disposed on the gate insulating layer;
an interlayer insulating layer covering the gate and an exposed portion of the gate insulating layer, wherein the interlayer insulating layer includes a plurality of first via holes extending to the drain and the second conductor portion;
a plurality of first auxiliary conductor portions and a third auxiliary conductor portion that are patterned and disposed on the interlayer insulating layer for receiving input signals, wherein each first via hole is filled with a respective first auxiliary conductor portion;
a planarization layer disposed on the interlayer insulating layer and an exposed portion of the gate insulating layer, wherein the planarization layer surrounds the first auxiliary conductor portions and the third auxiliary conductor portion, and the planarization layer includes a sixth via hole extending to the gate insulating layer; an orthographic projection of the sixth via hole on the substrate is located within an orthographic projection of the semiconductor portion on the substrate; and
the gate of the photosensitive device that is patterned and disposed on the planarization layer, wherein the gate of the photosensitive device is connected to the third auxiliary conductor portion, and the sixth via hole is filled with the gate of the photosensitive device.

16. The display substrate according to claim 13, wherein the display substrate comprises:
a semiconductor layer that is patterned and disposed on the substrate, wherein the semiconductor layer includes the active layer, the source and the drain of the low-temperature polycrystalline silicon thin film transistor, as well as the semiconductor portion, the first conductor portion and the second conductor portion of the photosensitive device; the source and the drain, and the first conductor portion and the second conductor portion are formed from a semiconductor material of the semiconductor layer by conductorization;
a gate insulating layer covering the semiconductor layer and an exposed portion of the substrate;
a gate layer that is patterned and disposed on the gate insulating layer, wherein the gate layer includes a gate of the low-temperature polycrystalline silicon thin film transistor and the gate of the photosensitive device; the gate of the low-temperature polycrystalline silicon thin film transistor includes a first gate and a second gate that are stacked, the gate of the photosensitive device is disposed in a same layer as the first gate, and the first gate is made of a transparent material;
an interlayer insulating layer covering the gate layer and an exposed portion of the gate insulating layer, wherein the interlayer insulating layer includes a plurality of first via holes extending to the drain and the second conductor portion;
a plurality of first auxiliary conductor portions that are patterned and disposed on the interlayer insulating layer for receiving input signals, wherein each first via hole is filled with a respective first auxiliary conductor portion; and
a planarization layer disposed on the interlayer insulating layer and surrounding the first auxiliary conductor portions.

17. A liquid crystal display panel, comprising the display substrate according to any one of claims 1 to 16, and the liquid crystal display panel further comprising:
a light-blocking layer and a buffer layer covering the light-blocking layer that are disposed on the substrate of the display substrate, wherein the buffer layer is located on a side of an active layer of the photosensitive device of the display substrate proximate to the substrate; an orthographic projection of the light-blocking layer on the substrate covers an orthographic projection of an active layer of a low-temperature polycrystalline silicon thin film transistor on the substrate and covers an orthographic projection of the semiconductor portion of the photosensitive device of the display substrate on the substrate; and
a common electrode disposed on a planarization layer, a passivation layer covering the common electrode, and a pixel electrode disposed on the passivation layer.

18. An electroluminescent diode display panel, comprising the display substrate according to any one of claims 1 to 16.

19. A display apparatus, comprising: the liquid crystal display panel according to claim 17 or electroluminescent diode display panel according to claim 18, and a driver chip; wherein
the driver chip is used to output a signal to the photosensor of the display substrate of the liquid crystal display panel or the electroluminescent diode display panel to drive the photosensitive device of the photosensor.

20. The display apparatus according to claim 19, wherein the photosensor further includes a low-temperature polycrystalline silicon thin film transistor, and the driver chip is further used to output a signal to the photosensor of the display substrate of the liquid crystal display panel or the electroluminescent diode display panel to drive the low-temperature polycrystalline silicon thin film transistor of the photosensor.

21. The display apparatus according to claim 19, wherein the display apparatus further comprises a sampling circuit and an operation circuit; wherein
the sampling circuit is used to obtain a current difference between a reference current and a photosensitive current that are output by the photosensor and to convert the current difference into a voltage difference; and
the operation circuit is used to obtain illuminance of external light based on the voltage difference.

22. A manufacturing method of a display substrate, wherein the display substrate having a display region and a non-display region, and
the manufacturing method of the display substrate comprises:
forming a driving circuit layer on a substrate, wherein the driving circuit layer includes a photosensor in the non-display region, and the photosensor includes a photosensitive device; the photosensitive device includes a semiconductor portion, a first conductor portion and a second conductor portion; the photosensitive device further includes a gate, and at least a portion of the gate is a light-transmitting portion; a material of the light-transmitting portion is a light-transmitting material, and the light-transmitting portion penetrates through the gate; and an orthographic projection of the light-transmitting portion on the substrate overlaps with an orthographic projection of the semiconductor portion on the substrate.

23. The manufacturing method of the display substrate according to claim 22, wherein
forming the driving circuit layer on the substrate further includes: forming the photosensor located in the non-display region, wherein the photosensor further includes a low-temperature polycrystalline silicon thin film transistor; the low-temperature polycrystalline silicon thin film transistor includes an active layer disposed in a same layer as the semiconductor portion of the photosensitive device, a source disposed in a same layer as the first conductor portion of the photosensitive device, and a drain disposed in a same layer as the second conductor portion of the photosensitive device; the photosensitive device outputs a photosensitive current in response to an input signal and illumination of external light on the semiconductor portion, and the low-temperature polycrystalline silicon thin film transistor outputs a reference current in response to an input signal.

24. The manufacturing method of the display substrate according to claim 23, wherein after forming the driving circuit layer on the substrate, the manufacturing method of the display substrate further comprises:
forming a black matrix, in the non-display region, on the driving circuit layer, wherein an orthographic projection of the black matrix on the substrate covers an orthographic projection of one of two photosensitive devices on the substrate, and the orthographic projection of the black matrix on the substrate is non-overlapping with an orthographic projection of another of the two photosensitive devices on the substrate; or
forming a black matrix, in the non-display region, on the driving circuit layer, wherein an orthographic projection of the black matrix on the substrate covers an orthographic projection of the low-temperature polycrystalline silicon thin film transistor on the substrate, and the orthographic projection of the black matrix on the substrate is non-overlapping with an orthographic projection of the photosensitive device on the substrate.

25. The manufacturing method of the display substrate according to claim 23 or 24, wherein forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming a interlayer insulating layer that is patterned by using a semi-transparent mask, wherein the semi-transparent mask has different transmittances corresponding to the gate of the low-temperature polycrystalline silicon thin film transistor and the gate portion of the photosensitive device; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate;
etching the gate portion of the photosensitive device to expose the gate insulating layer;
forming a plurality of first via holes extending to the drain and the second conductor portion in the interlayer insulating layer;
forming a plurality of first auxiliary conductor portions that are patterned on the interlayer insulating layer, wherein each first via hole is filled with a respective first auxiliary conductor portion; and
forming a planarization layer on the interlayer insulating layer and an exposed portion of the gate insulating layer, wherein the planarization layer surrounds the first auxiliary conductor portions.

26. The manufacturing method according to claim 23 or 24, wherein forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer by using a semi-transparent mask, wherein the gate layer includes a gate of the low-temperature polycrystalline silicon thin film transistor and a gate portion of the photosensitive device; the semi-transparent mask has different transmittances corresponding to the gate and the gate portion;
performing a first conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
etching the gate portion of the photosensitive device to expose the gate insulating layer;
performing a second conductorization process on the semiconductor layer;
forming an interlayer insulating layer on the gate and an exposed portion of the gate insulating layer, wherein the interlayer insulating layer includes a plurality of first via holes extending to the drain and the second conductor portion;
forming a plurality of first auxiliary conductor portions that are patterned on the interlayer insulating layer, wherein each first via hole is filled with a respective first auxiliary conductor portion; and
forming a planarization layer on the interlayer insulating layer, wherein the planarization layer surrounds the first auxiliary conductor portions.

27. The manufacturing method according to claim 23 or 24, wherein forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer that is patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming an interlayer insulating layer that is patterned by using a semi-transparent mask, wherein the semi-transparent mask has different transmittances corresponding to the gate of the low-temperature polycrystalline silicon thin film transistor and the gate portion of the photosensitive device respectively; an orthographic projection of the interlayer insulating layer on the substrate covers the orthographic projection of the gate of the low-temperature polycrystalline silicon thin film transistor on the substrate, and the interlayer insulating layer partially covers an exposed portion of the gate insulating layer; the orthographic projection of the interlayer insulating layer on the substrate is non-overlapping with the orthographic projection of the gate portion of the photosensitive device on the substrate;
etching the gate portion of the photosensitive device to expose the gate insulating layer;
forming a plurality of first via holes extending to the drain and second conductor portion in the interlayer insulating layer and forming a third via hole extending to the gate insulating layer in the interlayer insulating layer;
forming a plurality of first auxiliary conductor portions and a third auxiliary conductor portion that are patterned on the interlayer insulating layer, wherein each first via hole is filled with a respective first auxiliary conductor portion;
forming a planarization layer on the interlayer insulating layer, the third auxiliary conductor portion and a portion of gate insulating layer exposed by the third via hole, wherein the planarization layer surrounds the first auxiliary conductor portions;
forming a fourth via hole extending to the third auxiliary conductor portion in the planarization layer and forming a fifth via hole extending to the gate insulating layer in the planarization layer, wherein an orthographic projection of the fifth via hole on the substrate is located within the orthographic projection of the semiconductor portion of the photosensitive device on the substrate, and the orthographic projection of the fifth via hole on the substrate is located within an orthographic projection of the third via hole on the substrate; and
forming the gate of the photosensitive device that is patterned on the planarization layer, wherein the fourth via hole and the fifth via hole are filled with the gate of the photosensitive device, and the gate of the photosensitive device is connected to the third auxiliary conductor portion through the fourth via hole.

28. The manufacturing method according to claim 23 or 24, wherein forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a gate layer patterned on the gate insulating layer, wherein the gate layer includes a gate of the low-temperature polycrystalline silicon thin film transistor and a gate portion of the photosensitive device;
performing a conductorization process on the semiconductor layer, such that the semiconductor structure of the low-temperature polycrystalline silicon thin film transistor is formed into an active layer, and a source and a drain respectively disposed on two sides of the active layer, and the semiconductor structure of the photosensitive device is formed into a semiconductor portion, a first conductor portion and a second conductor portion, wherein an orthographic projection of the gate of the low-temperature polycrystalline silicon thin film transistor on the substrate and an orthographic projection of the active layer on the substrate overlap, and an orthographic projection of the gate portion of the photosensitive device on the substrate and an orthographic projection of the semiconductor portion on the substrate overlap;
forming an interlayer insulating layer on the gate layer and an exposed portion of the gate insulating layer, wherein the interlayer insulating layer includes a plurality of first via holes extending to the drain and the second conductor portion;
forming a plurality of first auxiliary conductor portions and a third auxiliary conductor portion that are patterned on the interlayer insulating layer, wherein each first via hole is filled with a respective first auxiliary conductor portion;
forming a planarization material layer on the interlayer insulating layer, wherein the planarization material layer surrounds the first auxiliary conductor portions and the third auxiliary conductor portion;
forming a planarization layer including a sixth via hole extending to the gate insulating layer in the planarization material layer and etching the gate portion through the sixth via hole to expose the gate insulating layer by using a semi-transparent mask, wherein an orthographic projection of the sixth via hole on the substrate is located within the orthographic projection of the gate portion on the substrate; the semi-transparent mask has different transmittances corresponding to the gate of the low-temperature polycrystalline silicon thin film transistor and the gate portion of the photosensitive device; and
forming the gate of the photosensitive device that is patterned on the planarization layer, wherein the sixth via hole is filled with the gate of the photosensitive device, and the gate of the photosensitive device is connected to the third auxiliary conductor portion.

29. The manufacturing method according to claim 23 or 24, wherein forming the driving circuit layer on the substrate includes:
forming a semiconductor layer that is patterned on the substrate, wherein the semiconductor layer includes a semiconductor structure of the low-temperature polycrystalline silicon thin film transistor and a semiconductor structure of the photosensitive device;
forming a gate insulating layer covering the semiconductor layer and an exposed portion of the substrate;
forming a first gate material layer and a second gate material layer that are stacked on the gate insulating layer, wherein the first gate material layer is made of a transparent material;
patterning the first gate material layer and the second gate material layer that are stacked by using a semi-transparent mask to form a gate layer, and performing a conductorization process on the semiconductor layer, wherein the gate layer includes a gate of the low-temperature polycrystalline silicon thin film transistor and the gate of the photosensitive device; the gate of the low-temperature polycrystalline silicon thin film transistor includes a first gate formed by patterning the first gate material layer, and a second gate formed by patterning the second gate material layer, and the first gate and the second gate are stacked; the gate of the photosensitive device is disposed in a same layer as the first gate; the semi-transparent mask has different transmittances corresponding to the gate of the low-temperature polycrystalline silicon thin film transistor and the gate of the photosensitive device; the semiconductor structure of the low-temperature polycrystalline silicon thin film transistor is formed into an active layer, and a source and a drain respectively disposed on two sides of the active layer; the semiconductor structure of the photosensitive device is formed into a semiconductor portion, a first conductor portion and a second conductor portion; an orthographic projection of the gate of the low-temperature polycrystalline silicon thin film transistor on the substrate and an orthographic projection of the active layer on the substrate overlap, and an orthographic projection of the gate of the photosensitive device on the substrate and an orthographic projection of the semiconductor portion on the substrate overlap;
forming an interlayer insulating layer covering the gate layer and an exposed portion of the gate insulating layer, wherein the interlayer insulating layer includes a plurality of first via holes extending to the drain and the second conductor portion;
forming a plurality of first auxiliary conductor portions that are patterned on the interlayer insulating layer, wherein each first via hole is filled with a respective first auxiliary conductor portion; and
forming a planarization layer on the interlayer insulating layer, wherein the planarization layer surrounds the first auxiliary conductor portions.

30. An ambient light detection method with the display apparatus according to claim 19, comprising:
the driver chip outputting driving signals to the photosensor of the display apparatus to drive the low-temperature polycrystalline silicon thin film transistor and the photosensitive device of the photosensor, such that the low-temperature polycrystalline silicon thin film transistor outputs a reference current, and the photosensitive device outputs a photosensitive current in response to illumination of external light;
obtaining, based on the reference current and the photosensitive current that are output by the photosensor, a current difference between the reference current and the photosensitive current, and converting the current difference into a voltage difference through a preset sampling circuit; and
obtaining, based on the voltage difference, illuminance of the external light through a preset operation circuit.
